(19) Europäisches Patentamt
European Patent Office
Office européen des brevets

(11) EP 4 797 446 A1

(12) **EUROPEAN PATENT APPLICATION**
published in accordance with Art. 153(4) EPC

(43) Date of publication:
**26.08.2026 Bulletin 2026/35**

(21) Application number: **23956170.7**

(22) Date of filing: **17.10.2023**

(51) International Patent Classification (IPC):
***H01Q 1/38*** (2006.01) ***H05K 1/14*** (2006.01)
***H01Q 1/32*** (2006.01) ***H01Q 1/12*** (2006.01)
***H01R 13/59*** (2006.01)

(52) Cooperative Patent Classification (CPC):
**H01Q 1/12; H01Q 1/32; H01Q 1/38; H01R 13/59; H05K 1/14**

(86) International application number:
**PCT/KR2023/016062**

(87) International publication number:
**WO 2025/084448 (24.04.2025 Gazette 2025/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **LG Electronics Inc.**
**Yeongdeungpo-gu**
**Seoul 07336 (KR)**

(72) Inventors:
- **JUNG, Kangjae**
  **Seoul 06772 (KR)**
- **KIM, Dongjin**
  **Seoul 06772 (KR)**
- **KIM, Uisheon**
  **Seoul 06772 (KR)**
- **JUNG, Byungwoon**
  **Seoul 06772 (KR)**
- **LEE, Soyeon**
  **Seoul 06772 (KR)**
- **CHOI, Kukheon**
  **Seoul 06772 (KR)**
- **PARK, Byeongyong**
  **Seoul 06772 (KR)**

(74) Representative: **Vossius & Partner**
**Patentanwälte Rechtsanwälte mbB**
**Siebertstraße 3**
**81675 München (DE)**

# (54) FLEXIBLE PRINTED CIRCUIT BOARD AND ANTENNA ASSEMBLY INCLUDING SAME

(57) The present disclosure relates to a flexible printed circuit board and an antenna assembly including same, the flexible printed circuit board comprising a plurality of layers and including a first substrate unit, a second substrate unit, and a third substrate unit, wherein: the third substrate unit includes a third power supply pattern and a third ground pattern; both ends of the third power supply pattern are electrically connected to a first power supply pattern and a second power supply pattern respectively; both ends of the third ground pattern are electrically connected to a first ground pattern and a second ground pattern respectively; the third power supply pattern includes a first power supply part adjacent to one surface of glass, a second power supply part adjacent to a side edge of the glass, and a third power supply part adjacent to the other surface of the glass; and the distance between orthogonal projections of the first power supply part and the third power supply part may increase as being farther away from the second power supply part.

FIG. 1

1
HEIGHT DIRECTION(H)
WIDTH DIRECTION(W)
OVERALL-LENGTH DIRECTION(L)

EP 4 797 446 A1

## Description

[Technical Field]

The present disclosure relates to a flexible printed circuit board and an antenna assembly including the same, and more particularly, to a flexible printed circuit board electrically connected to an antenna and an antenna assembly including the same.

[Background Art]

A vehicle refers to a means of transporting people or goods using kinetic energy. A representative example of a vehicle is a car.

Recently, development of various systems applied to vehicles for the convenience and safety of users has been actively carried out. In particular, the importance of wireless communication systems that enable a vehicle to perform wireless communication with other vehicles, nearby objects, base stations, and the like is increasing. In addition, it is expected that wireless communication systems using 5G communication technology will be commercialized in the future, thereby allowing a wider variety of services to be provided through vehicles.

Conventionally, an antenna for performing wireless communication is configured as a separate structure on one side of a vehicle body, or is disposed under the vehicle body or a vehicle roof. However, when the antenna is configured as a separate structure on one side of the vehicle body, an area where the antenna is placed is visually distinguished from other areas and becomes conspicuous, which may be disadvantageous in terms of design. In addition, when the antenna is disposed under the vehicle body or roof, the efficiency of the antenna is significantly reduced due to the material of the vehicle body or roof.

Meanwhile, in consideration of design aspects and antenna efficiency, a transparent antenna may be placed on vehicle glass. Conventionally, for feeding the transparent antenna, an RF cable is connected, by soldering, to a board connected to the transparent antenna. However, the conventional method has problems such as inconvenient assembly between components related to the transparent antenna and an increase in volume. In addition, when the transparent antenna operates as a wideband antenna, a method is required to minimize feed loss to the antenna and maximize antenna efficiency.

[Technical Problem]

An object of the present disclosure is to solve the aforementioned problems and other drawbacks.

Another object of the present disclosure is to provide a flexible printed circuit board that stably connects an antenna and a connector, and an antenna assembly including the same.

Another object of the present disclosure is to provide a flexible printed circuit board having various structures optimized for a position of a glass to which an antenna is attached among two sheets of glass, and an antenna assembly including the same.

Another object of the present disclosure is to provide a flexible printed circuit board with a minimized thickness, and an antenna assembly including the same.

Another object of the present disclosure is to provide a flexible printed circuit board that can reduce feed loss for an antenna operating in a wideband, and an antenna assembly including the same.

Another object of the present disclosure is to provide a flexible printed circuit board that can improve efficiency of an antenna operating in a wideband, and an antenna assembly including the same.

Another object of the present disclosure is to provide a flexible printed circuit board that can reduce feed loss by preventing interference between feed lines, and an antenna assembly including the same.

Another object of the present disclosure is to provide a flexible printed circuit board that can provide an antenna optimized for the area of an opaque region of a glass, and an antenna assembly including the same.

[Technical Solution]

In accordance with one aspect of the present disclosure, the above and other objects can be accomplished by providing a flexible printed circuit board composed of a plurality of layers, the flexible printed circuit board including: a first board portion including a first feed pattern disposed on any one of the plurality of layers and electrically connected to an antenna, and a plurality of first ground patterns disposed on both sides of the first feed pattern; a second board portion including a second feed pattern disposed on any one of the plurality of layers and electrically connected to a cable, and a plurality of second ground patterns disposed on both sides of the second feed pattern; and a third board portion disposed between the first board portion and the second board portion, and covering a portion of a lateral side of a glass, wherein the third board portion includes a third feed pattern disposed on a first layer of the plurality of layers that is adjacent to the glass, and a third ground pattern disposed on a second layer, wherein both ends of the third feed pattern are electrically connected to the first feed pattern and the second feed pattern, respectively, and both ends of the third ground pattern are electrically connected to the first ground pattern and the second ground pattern, respectively, wherein the third feed pattern includes a first feed part adjacent to one surface of the glass, a second feed part adjacent to the lateral side of the glass, and a third feed part adjacent to the other surface of the glass, and wherein a gap between orthogonal projections of the first feed part and the third feed part increases as a distance from the second feed part increases.

In accordance with another aspect of the present disclosure, there is provided an antenna assembly including: a main antenna including a main feed line and a plurality of main ground patterns; a sub-antenna including a sub-feed line connected to the main feed line, and a plurality of sub-ground patterns connected to the plurality of main ground patterns; and a flexible printed circuit board composed of a plurality of layers, the flexible printed circuit board including: a first board portion including a first feed pattern disposed on any one of the plurality of layers and connected to the sub-feed line, and a plurality of first ground patterns connected to the plurality of sub-ground patterns; a second board portion including a second feed pattern disposed on any one of the plurality of layers and electrically connected to a cable, and a plurality of second ground patterns disposed on both sides of the second feed pattern; and a third board portion disposed between the first board portion and the second board portion and covering a portion of a lateral side of a glass, wherein the third board portion includes a third feed pattern disposed on a first layer of the plurality of layers that is adjacent to the glass, and a third ground pattern disposed on a second layer, wherein both ends of the third feed pattern are electrically connected to the first feed pattern and the second feed pattern, respectively, and both ends of the third ground pattern are electrically connected to the first ground pattern and the second ground pattern, respectively, wherein the third feed pattern includes a first feed part adjacent to one surface of the glass, a second feed part adjacent to the lateral side of the glass, and a third feed part adjacent to the other surface of the glass, and wherein a gap between orthogonal projections of the first feed part and the third feed part increases as a distance from the second feed part increases.

[Advantageous Effects]

A flexible printed circuit board and an antenna assembly including the same according to the present disclosure have the following effects.

According to at least one of the embodiments of the present disclosure, it is possible to stably connect an antenna and a connector.

In addition, according to at least one of the embodiments of the present disclosure, it is possible to provide various structures optimized for a position of a glass to which an antenna is attached among two sheets of glass.

Further, according to at least one of the embodiments of the present disclosure, it is possible to minimize a thickness of a flexible printed circuit board.

Further, according to at least one of the embodiments of the present disclosure, it is possible to reduce feed loss for an antenna operating in a wideband.

Further, according to at least one of the embodiments of the present disclosure, it is possible to improve efficiency of an antenna operating in a wideband.

Further, according to at least one of the embodiments of the present disclosure, it is possible to prevent interference between feed lines, thereby reducing feed loss.

Further, according to at least one of the embodiments of the present disclosure, it is possible to provide an antenna optimized for the area of an opaque region of a glass.

Further scope of applicability of the present disclosure will become apparent from the following detailed description. However, it should be understood that the detailed description and specific embodiments such as preferred embodiments of the present disclosure are given by way of example only, since various changes and modifications within the idea and scope of the present disclosure may be clearly understood by those skilled in the art.

[Brief Description of Drawings]

FIG. 1 illustrates an outer appearance of a vehicle according to an embodiment of the present disclosure.

FIGS. 2 and 3 are diagrams for explaining a position in which an antenna is disposed, according to an embodiment of the present disclosure.

FIG. 4 is a block diagram for explaining a vehicle according to an embodiment of the present disclosure.

FIGS. 5 to 16 are diagrams for explaining an antenna assembly according to embodiments of the present disclosure.

FIGS. 17 to 23 are diagrams for explaining a flexible printed circuit board and an antenna assembly, according to one embodiment of the present disclosure.

FIGS. 24 to 27 are diagrams for explaining a flexible printed circuit board and an antenna assembly, according to another embodiment of the present disclosure.

FIGS. 28 to 39 are diagrams for explaining a flexible printed circuit board and an antenna assembly, according to yet another embodiment of the present disclosure.

FIGS. 40 to 51 are diagrams for explaining a flexible printed circuit board and an antenna assembly, according to still another embodiment of the present disclosure.

[Mode for the Invention]

Description will now be given in detail according to exemplary embodiments disclosed herein, with reference to the accompanying drawings. For the sake of brief description with reference to the drawings, the same or equivalent components may be denoted by the same

reference numbers, and description thereof will not be repeated.

In the following description, a suffix such as "module" and "unit" may be used to refer to elements or components. Use of such a suffix herein is merely intended to facilitate description of the specification, and the suffix itself is not intended to give any special meaning or function.

Terms such as "comprises or includes" or "has" are used herein and should be understood that they are intended to indicate an existence of features, numbers, steps, operations, elements, components, or combinations thereof, disclosed in the specification, but do not preclude the presence or addition of one or more other features, numbers, steps, operations, elements, components, or combinations thereof.

Although the terms "first", "second", etc. may be used herein to describe various elements, these elements should not be limited by these terms. These terms are only used to distinguish one element from another.

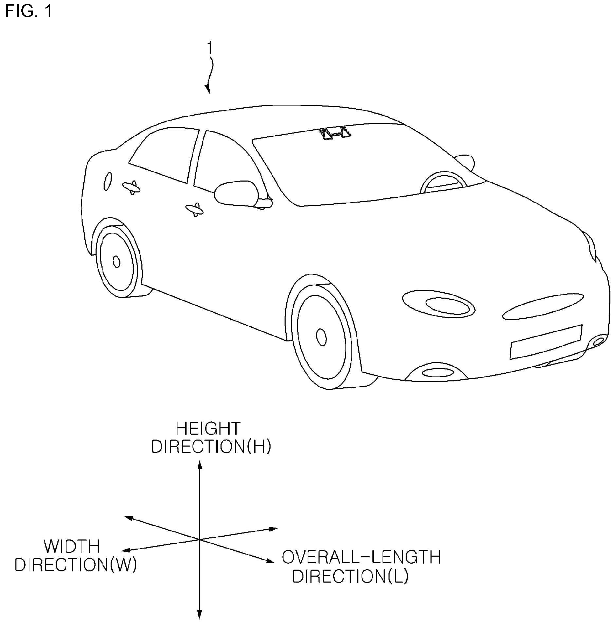

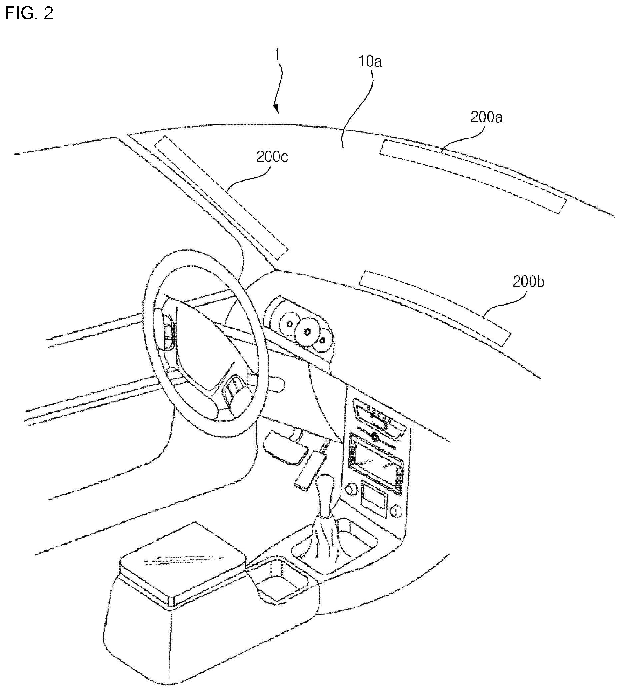

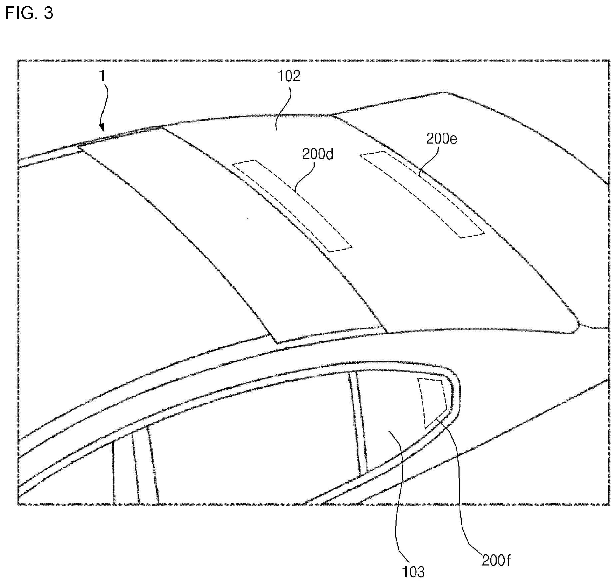

Referring to FIGS. 1 to 3, the term "overall length" refers to a length from the front end to the rear end of a vehicle 1, the term "width" refers to a lateral dimension of the vehicle 1, and the term "height" refers to a length from the bottom of a wheel to a roof. In the following description, an overall length direction L may indicate a direction used as a reference for measuring the overall length of the vehicle 1, a width direction W may indicate a direction used as a reference for measuring the width of the vehicle 1, and a height direction H may indicate a direction used as a reference for measuring the height of the vehicle 1.

The vehicle 1 may include at least one antenna for performing communication. For example, the vehicle 1 may include a transmitting antenna for transmitting a signal, a receiving antenna for receiving a signal, and/or a transmitting/receiving antenna for transmitting or receiving a signal. The vehicle 1 may transmit and receive signals of various frequency bands through the antenna. For example, the vehicle 1 may transmit and receive signals such as GPS, 4G wireless communication, 5G wireless communication, Bluetooth, and wireless LAN.

The vehicle 1 may perform communication through an antenna. The vehicle 1 may perform V2X (Vehicle-to-Everything) communication. The V2X communication may include V2V (Vehicle-to-Vehicle) communication between vehicles, V2I (Vehicle-to-Infrastructure) communication between a vehicle and infrastructure such as a base station (eNB) and a road side unit (RSU), V2P (Vehicle-to-Pedestrian) communication between a vehicle and a user terminal, V2N (Vehicle-to-Network) communication between a vehicle and a network, and the like.

The vehicle 1 may include a transparent antenna made of a transparent material. The transparent antenna may be implemented by forming an antenna pattern on a substrate made of a transparent material. In the present disclosure, the transparent substrate is described, by way of example, as being made of polyethylene terephthalate (PET), but the present disclosure is not limited thereto.

The transparent antenna may be disposed in or on a dielectric included in the vehicle 1. The transparent antenna may be disposed in an upper region 200a, a lower region 200b, and/or a side region 200c of a windshield 10a of the vehicle 1. The transparent antenna may also be disposed in an upper region 200d and/or a lower region 200e of a rear windshield 10b of the vehicle 1, in a region 200f of a quarter glass 10c, etc. For example, the vehicle 1 may transmit and receive a signal corresponding to the overall length direction L through the transparent antenna disposed on the windshield 10a and/or the rear windshield 10b. For example, the vehicle 1 may transmit and receive a signal corresponding to the width direction W through the transparent antenna disposed on the quarter glass 10c.

Hereinafter, a description will be given on the assumption that the vehicle 1 performs Sub-6GHz 5G communication using a frequency of 6GHz or less through the transparent antenna.

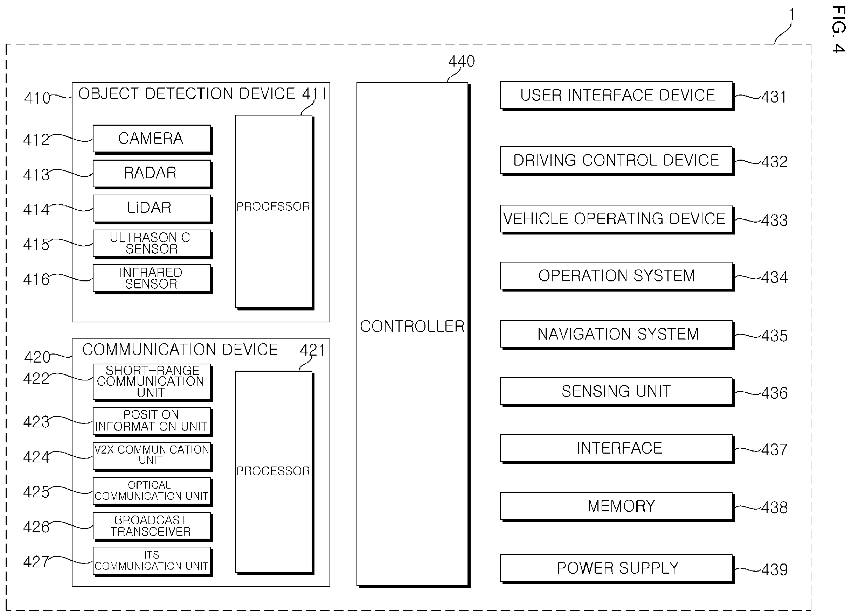

Referring to FIG. 4, the vehicle 1 may include an object detection device 410, a communication device 420, a user interface device 431, a driving control device 432, a vehicle operating device 433, an operation system 434, a navigation system 435, a sensing unit 436, an interface 437, a memory 438, a power supply 439, and/or a controller 440. In some embodiments, the vehicle 1 may further include components other than those described herein, or may not include some of the components described herein.

The object detection device 410 is a device for detecting an object located outside the vehicle 1. The object may be various objects related to the operation of the vehicle 1. The object may be classified into a moving object and a stationary object. For example, the moving object may include another vehicle in motion and a pedestrian in motion. For example, the stationary object may include a traffic signal, a road, a structure, another vehicle at rest, and a stationary pedestrian.

The object detection device 410 may include a processor 411, a camera 412, a radar 413, a LiDAR 414, an ultrasonic sensor 415, and/or an infrared sensor 416. In some embodiments, the object detection device 410 may further include components other than the components described herein, or may not include some of the components described herein.

The processor 411 may control the overall operation of each unit of the object detection device 410. The processor 411 may generate object information based on data acquired through each unit of the object detection device 410. The object information may include information regarding the presence or absence of an object, position information of the object, distance information between the vehicle 1 and the object, relative speed information between the vehicle 1 and the object, and the like.

In some embodiments, the object detection device 410 may include a plurality of processors 411 or may not include a processor 411. For example, each of the camera 412, the radar 413, the LiDAR 414, the ultrasonic sensor 415, and/or the infrared sensor 416 may individually include a processor. The object detection device 410 may be operated under the control of a processor or a controller 170 of another device in the vehicle 1.

The communication device 420 is a device for performing communication with an external device. Here, the external device may be another vehicle, a mobile terminal, or a server. To enable communication, the communication device 420 may include at least one of a transmitting antenna, a receiving antenna, a radio frequency (RF) circuit capable of implementing various communication protocols, and an RF component.

The communication device 420 may include a processor 421, a short-range communication unit 422, a position information unit 423, a V2X communication unit 424, an optical communication unit 425, a broadcast transceiver 426, and/or an ITS communication unit 427. In some embodiments, the communication device 420 may further include components other than the components described herein, or may not include some of the components described herein.

The processor 421 may control the overall operation of each unit of the communication device 420. The processor 421 may transmit and receive signals through each unit of the communication device 420. In some embodiments, the communication device 420 may include a plurality of processors 421 or may not include the processor 421. When the processor 421 is not included in the communication device 420, the communication device 420 may be operated under the control of a processor or a controller 170 of another device in the vehicle 1.

The short-range communication unit 422 is a unit for short-range communication. The short-range communication unit 422 may support short-range communication using at least one selected from among Bluetooth, Radio Frequency Identification (RFID), Infrared Data Association (IrDA), Ultra-WideBand (UWB), ZigBee, Near Field Communication (NFC), Wireless-Fidelity (Wi-Fi), Wi-Fi Direct, and Wireless Universal Serial Bus (Wireless USB). The short-range communication unit 422 may establish wireless area networks to enable short-range communication between the vehicle 1 and at least one external device.

The position information unit 423 is a unit for obtaining position information of the vehicle 1. For example, the position information unit 423 may include a global positioning system (GPS) module or a differential global positioning system (DGPS) module.

The V2X communication unit 424 is a unit for performing V2X communication such as Vehicle-to-Vehicle (V2V), Vehicle-to-Infrastructure (V2I), Vehicle-to-Pedestrian (V2P), and Vehicle-to-Network (V2N). The V2X communication unit 424 may include an RF circuit configured to implement protocols for communication with infrastructure (V2I), communication between vehicles (V2V), communication with a pedestrian (V2P), and communication with a network (V2N).

The intelligent transport systems (ITS) communication unit 427 may exchange information, data, or signals with a traffic system. For example, the ITS communication unit 427 may receive traffic information from the traffic system and provide the traffic information to the controller 440. For example, the ITS communication unit 427 may receive a control signal from the traffic system and provide the control signal to the controller 440 or a processor provided in the vehicle 1.

The user interface device 431 is a device for communication between the vehicle 1 and a user. The user interface device 431 may receive a user input and provide information generated in the vehicle 1 to a user. The vehicle 1 may implement user interfaces (UI) or user experience (UX) through the user interface device 431.

The user interface device 431 may include an input unit configured to receive a user input from a user, an internal camera configured to capture an image inside the vehicle 1, a biometric sensing unit configured to obtain biometric information such as user's fingerprint information and heart rate information, an output unit configured to generate an output related to vision, hearing, or touch, a processor, and the like. In some embodiments, the user interface device 431 may further include components other than the components described herein, or may not include some of the components described herein.

The driving control device 432 is a device that receives a user input for driving. The driving control device 432 may include a steering input device configured to receive an input for a traveling direction of the vehicle 1 from a user, an acceleration input device configured to receive an input for acceleration of the vehicle 1 from a user, and/or a brake input device configured to receive an input for deceleration of the vehicle 1 from a user.

The vehicle operating device 433 is a device that electrically controls driving of various devices inside the vehicle 1. The vehicle operating device 433 may include a powertrain driving unit, a chassis driving unit, a door/window driving unit, a safety device driving unit, a lamp driving unit, and/or an air conditioner driving unit. In some embodiments, the vehicle operating device 433 may further include components other than the components described herein, or may not include some of the components described herein.

The operation system 434 is a system that controls various operations of the vehicle 1. The operation system 434 may operate in an autonomous driving mode. The operation system 434 may provide a control signal to the vehicle operating device 433. The operation system 434 may include a driving system 710 configured to control driving of the vehicle 1, a parking exit system configured to control departure of the vehicle 1, and/or a

parking system configured to control parking of the vehicle 1. In some embodiments, the operation system 434 may further include components other than the components described herein, or may not include some of the components described herein.

The navigation system 435 may provide navigation information. The navigation information may include at least one of map information, set destination information, route information according to the set destination, information regarding various objects on the route, lane information, and current location information of the vehicle. In some embodiments, the navigation system 435 may update prestored information based on data received from the communication device 420.

The sensing unit 436 may sense the state of the vehicle. The sensing unit 436 may include an IMU (Inertial Navigation Unit) sensor, including an acceleration sensor and a gyro sensor, a collision sensor, a wheel sensor, a speed sensor, a tilt sensor, a weight detection sensor, a heading sensor, a position module, a vehicle forward/reverse sensor, a battery sensor, a fuel sensor, a tire sensor, a steering sensor based on steering wheel rotation, an in-vehicle temperature sensor, an in-vehicle humidity sensor, an ultrasonic sensor, an illumination sensor, an accelerator pedal position sensor, a brake pedal position sensor, and the like. In addition, the sensing unit 436 may further include an accelerator pedal sensor, a pressure sensor, an engine speed sensor, an air flow sensor (AFS), an air temperature sensor (ATS), a water temperature sensor (WTS), a throttle position sensor (TPS), a TDC sensor, a crank angle sensor (CAS), and the like.

The interface 437 may serve as a passage for various types of external devices connected to the vehicle 1. For example, the interface 437 may include a port that can be connected to a mobile terminal. In this case, the interface 437 may exchange data with the mobile terminal connected to the port.

The memory 438 is electrically connected to the controller 440. The memory 438 may store basic data for a unit, control data for controlling the operation of a unit, input/output data, and the like. The memory 438 may be any of various hardware storage devices such as ROM, RAM, EPROM, a flash drive, a hard drive, and the like. The memory 438 may store various data for the overall operation of the vehicle 1, such as a program for processing or controlling the controller 440.

In some embodiments, the memory 438 may be integrally formed with the controller 440, or may be implemented as a sub-component of the controller 440.

The power supply 439 may supply power required for the operation of each component. The power supply 439 may receive power from a battery in the vehicle or the like.

The controller 440 may control the overall operation of each unit in the vehicle 1. The controller 440 may be referred to as an electronic control unit (ECU).

One or more processors and the controller 440, which are included in the vehicle 1, may be implemented using at least one selected from among application specific integrated circuits (ASICs), digital signal processors (DSPs), digital signal processing devices (DSPDs), programmable logic devices (PLDs), field programmable gate arrays (FPGAs), processors, controllers, microcontrollers, microprocessors, and electrical units for performing other functions.

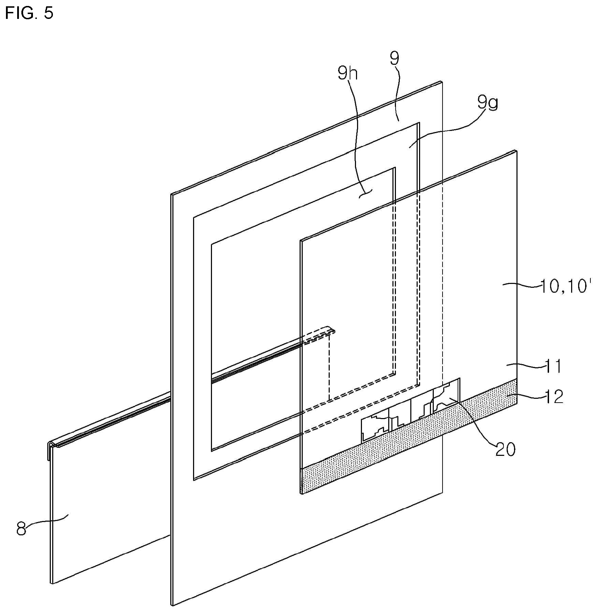

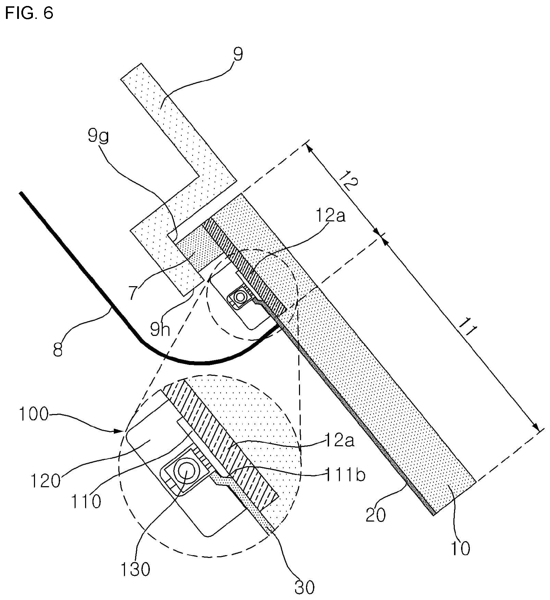

Referring to FIGS. 5 and 6, a glass 10, 10' may be coupled or attached to a frame 9 of the vehicle, and may cover an opening 9h of the frame 9. For example, the glass 10, 10' may be a glass of the vehicle 1, such as a front windshield 101, a door glass 102, 103, the quarter glass 104, the rear windshield, a side mirror, a sunroof 105, or a lamp glass 106 (see FIG. 1). A groove 9g of the frame 9 may extend along a periphery of the glass 10, 10', and may define a boundary of the opening 9h. For example, the frame 9 may include a metallic material, and a sealant 7 may be filled between the groove 9g and the glass 10, 10'.

An antenna 20 may be positioned on one surface of the glass 10 or inside the glass 10'. The antenna 20 may be transparent. The antenna 20 may be flexible.

A connection module 100 may be disposed between an edge of the glass 10, 10' and the antenna 20, and may be positioned on the one surface of the glass 10. A connector 130 of the connection module 100 may be electrically connected to the antenna 20 through a board 30. An inner cover 8 may be positioned opposite the glass 10, 10' with respect to the frame 9, and may cover the connection module 100. The inner cover 8 may be referred to as an interior cover 8. The connection module 100 may be referred to as a connector device 100 or a connector assembly 100.

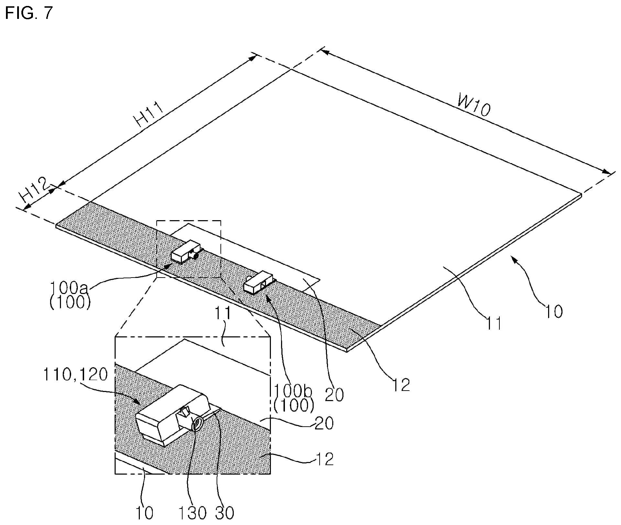

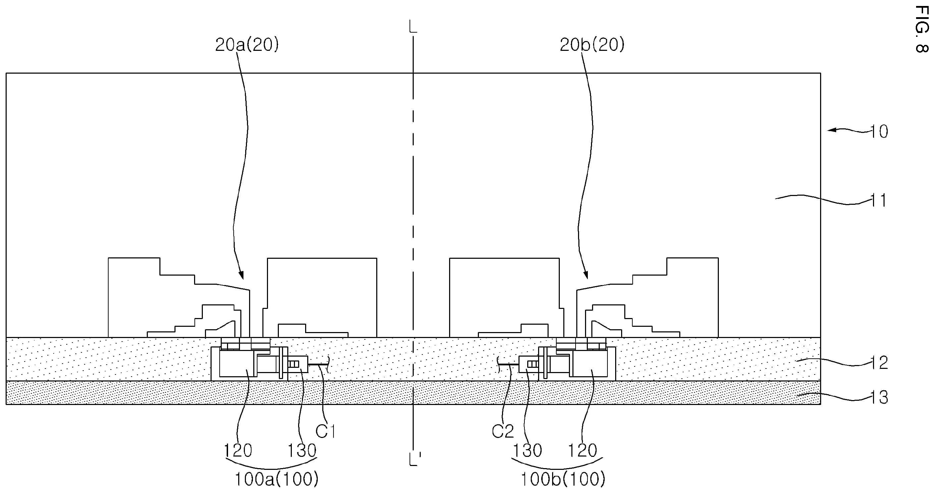

Referring to FIGS. 7 and 8, the glass 10' may be a laminated glass. That is, the glass 10' may include two sheets of glass, namely glass 10 and glass 10a, superimposed on each other. The first glass 10 may have a transparent region 11 and an opaque region 12. The opaque region 12 may be a black masking region or a frit region. For example, the transparent region 11 may occupy most of the glass 10, and the opaque region 12 may be adjacent to one edge of the glass 10. The transparent region 11 and the opaque region 12 may have the same width W10, and a height H11 of the transparent region 11 may be greater than a height H12 of the opaque region 12.

The second glass 10a may have only a transparent region. Alternatively, the second glass 10a may have a transparent region and an opaque region, as does the first glass 10.

The antenna 20 may be positioned between the first glass 10 and the second glass 10a corresponding to the transparent region 11. The connection module 100 may be positioned on a region of the second glass 10a that corresponds to the opaque region 12 of the first glass 10, and the connector 130 of the connection module 100 may be connected to the antenna 20 through the board

30. In this case, a portion of the board 30 may be positioned inside the glass 10', and another portion of the board 30 may be bent at one edge of the glass 10' to connect the portion of the board 30 and the connector 130. Meanwhile, the connection module 100 may be positioned to correspond to the transparent region 11.

The m antennas 20 may be positioned inside the glass 10', and the m connection modules 100 may be positioned on the glass 10' (where m is a natural number greater than or equal to 1). A first antenna 20a may be positioned inside the glass 10' to correspond to the transparent region 11, and may be electrically connected to a second connection module 100b. A second antenna 20b may be positioned inside the glass 10' next to the first antenna 20a, and may be electrically connected to a first connection module 100a. For example, the first antenna 20a and the second antenna 20b may be left-right symmetrical with respect to a center line LL' of the glass 10'. For example, the second connection module 100b and the first connection module 100a may be left-right symmetrical with respect to the center line LL' of the glass 10'.

Meanwhile, a packing member 13 made of rubber may be coupled or attached to a portion of the glass 10' that corresponds to the opaque region 12 and is adjacent to the connection module 100.

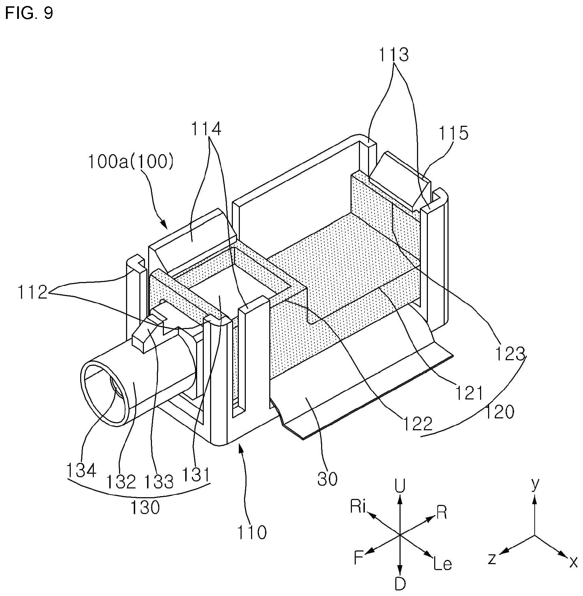

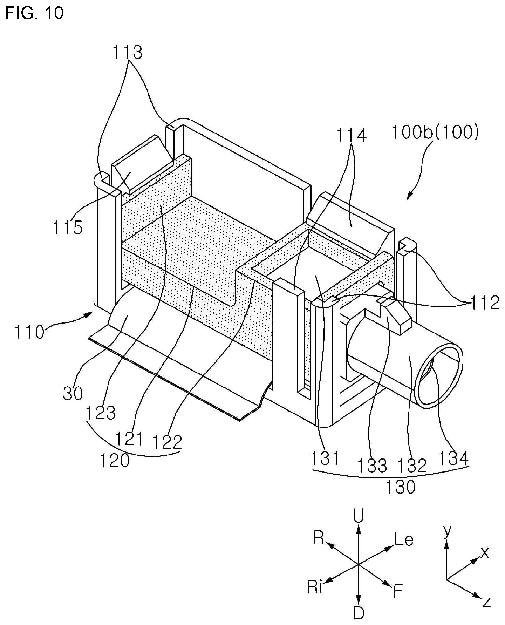

Referring to FIGS. 9 and 10, the directions "up (U)", "down (D)", "left (Le)", "right (Ri)", "front (F)", and "rear (R)" shown in the drawings are provided for convenience of description only, and are not intended to limit the technical scope of the present disclosure.

A pair of connection modules 100a and 100b may be symmetrically arranged left and right. That is, the description of the first connection module 100a may be symmetrically applied to the second connection module 100b (and vice versa). In addition, a first cable C1 connected to a jack 134 of the connector 130 of the first connection module 100a and a second cable C2 connected to a jack 134 of the connector 130 of the second connection module 100b may be horizontally arranged between the first connection module 100a and the second connection module 100b (see FIGS. 7 and 8). For example, the cables C1 and C2 may be detachably coupled to respective latches 133 of the connectors 130. The cables C1 and C2 may be referred to as coaxial cables or RF cables.

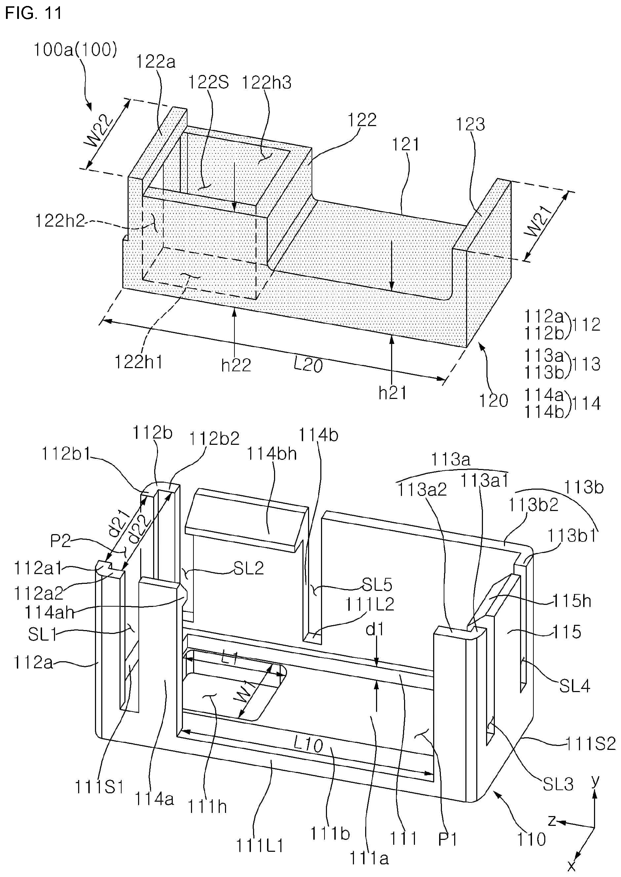

Referring to FIG. 11, the connection module 100 may include a lower housing 110 and an upper housing 120. The lower housing 110 may be referred to as a lower case 110, a bottom housing 110, or a bottom case 110. The upper housing 120 may be referred to as an upper case 120, a top housing 120, or a top case 120. The lower housing 110 and the upper housing 120 may be collectively referred to as a housing (110, 120) or a case (110, 120). For example, the housing (110, 120) may include a plastic material such as polycarbonate (PC).

The lower housing 110 may include a base 111 and walls 112, 113, 114, and 115. The base 111 may be referred to as a bottom plate 111.

The base 111 may have an overall rectangular plate shape, and may define a bottom of the housing (110, 120). For example, the base 111 may include two long sides 111L1 and 111L2 and two short sides 111S1 and 111S2. A flat surface portion 111a may be formed on an upper surface of the base 111, and the flat surface portion 111a may have a shape corresponding to the shape of the base 111. The flat surface portion 111a may be a groove, and may be referred to as a flat surface 111a. A hole 111h may be formed through the flat surface portion 111a in a thickness direction of the base 111. For example, the hole 111h may be a rectangular hole having a predetermined width W1 and a length L1, and may be adjacent to a first short side 111S1.

The walls 112, 113, 114, and 115 may protrude from edges of the base 111 in a direction intersecting the base 111. For example, the walls 112, 113, 114, and 115 may have the same or similar heights.

A front wall 112 may be positioned at the first short side 111S1. A first front wall 112a may protrude upward from a corner where the first short side 111S1 and a first long side 111L1 meet. A first part 112a1 of the first front wall 112a may extend along the first short side 111S1, a second part 112a2 of the first front wall 112a may extend along the first long side 111L1, and the first front wall 112a may have an "L"-shaped cross section. A second front wall 112b may protrude upward from a corner where the first short side 111S1 and a second long side 111L2 meet. A first part 112b1 of the second front wall 112b may extend along the first short side 111S1, a second part 112b2 of the second front wall 112b may extend along the second long side 111L2, and the second front wall 112b may have an "L"-shaped cross section. The first front wall 112a and the second front wall 112b may be spaced apart from each other in a longitudinal direction of the first short side 111S1, and may be symmetrical to each other with respect to a center of the first short side 111S1. A second distance d22 between the second parts 112a2 and 112b2 may be less than a first distance d21 between the first parts 112a1 and 112b1.

A rear wall 113 may be positioned at a second short side 111S2. A first rear wall 113a may protrude upward from a corner where the second short side 111S2 and the first long side 111L1 meet. A first part 113a1 of the first rear wall 113a may extend along the second short side 111S2, a second part 113a2 of the first rear wall 113a may extend along the first long side 111L1, and the first rear wall 113a may have an "L"-shaped cross section. A second rear wall 113b may protrude upward from a corner where the second short side 111S2 and the second long side 111L2 meet. A first part 113b1 of the second rear wall 113b may extend along the second short side 111S2, a second part 113b2 of the second rear wall 113b may extend along the second long side 111L2, and the second rear wall 113b may have an "L"-shaped cross section. The first rear wall 113a and the second rear wall 113b may be spaced apart from each other in a long-

itudinal direction of the second short side 111S2, and may be symmetrical to each other with respect to a center of the second short side 111S2. A second distance between the second parts 113a2 and 113b2 may be less than a first distance between the first parts 113a1 and 113b1. For example, the first and second distances may be equal to the first and second distances d21 and d22, respectively.

A side wall 114 may be positioned at the long sides 111L1 and 111L2. A first side wall 114a may protrude upward from the first long side 111L1, may extend along the first long side 111L1, and may be adjacent to the first short side 111S1. A first side hook 114ah may be formed on an inner surface of the first side wall 114a at a position adjacent to an end of the first side wall 114a. A second side wall 114b may protrude upward from the second long side 111L2, may extend along the second long side 111L2, and may face the first side wall 114a. A second side hook 114bh may be formed on an inner surface of the second side wall 114b at a position adjacent to an end of the second side wall 114b.

A central wall 115 may be positioned at a central portion of the second short side 111S2. The central wall 115 may protrude upward from the second short side 111S2, and may extend along the second short side 111S2. A central hook 115h may be formed on an inner surface of the central wall 115 at a position adjacent to an end of the central wall 115.

A first opening P1 may be formed between the first rear wall 113a and the first side wall 114a. A second opening P2 may be formed between the first front wall 112a and the second front wall 112b.

A first slit SL1 may be formed between the first front wall 112a and the first side wall 114a. A second slit SL2 may be formed between the second front wall 112b and the second side wall 114b. A third slit SL3 may be formed between the central wall 115 and the first rear wall 113a. A fourth slit SL4 may be formed between the central wall 115 and the second rear wall 113b. A fifth slit SL5 may be formed between the second side wall 114b and the second rear wall 113b. The slits SL1, SL2, SL3, SL4, and SL5 may be notches. Accordingly, the side wall 114 and the central wall 115 may be bent from other portions of the lower housing 110 or restored to their original states.

The upper housing 120 may be positioned above the base 111 of the lower housing 110. An edge of a lower surface of the upper housing 120 may form a closed shape that is identical or similar to a boundary of the flat surface portion 111a of the base 111. The upper housing 120 may be disposed between the flat surface portion 111a and the hooks 114ah, 114bh, and 115h inside the walls 112, 113, 114, and 115 of the lower housing 110. The upper housing 120 may include a cover portion 121, an accommodating portion 122, and an engaging portion 123.

The cover portion 121 may have a solid or hollow block shape. The cover portion 121 may face a first region of the flat surface portion 111a, and may be adjacent to the rear wall 113 and the central wall 115. The cover portion 121 may be referred to as a pressing portion 121 or a fixing portion 121.

The accommodating portion 122 may extend from one end (i.e., a front end) of the cover portion 121 toward the front wall 112, and may face a second region of the flat surface portion 111a. Here, the aforementioned hole 111h may be formed in the second region. An internal space 122S of the accommodating portion 122 may communicate with the hole 111h through a first hole 122h1 formed in one surface (i.e., a lower surface) of the accommodating portion 122 facing the hole 111h. The internal space 122S of the accommodating portion 122 may communicate with the second opening P2 through a second hole 122h2 formed in another surface (i.e., a front surface) of the accommodating portion 122 facing the second opening P2. Meanwhile, an upper surface of the accommodating portion 122 may be closed or opened through a third hole 122h3.

The engaging portion 123 may protrude from the other end (i.e., a rear end) of the cover portion 121 toward the central hook 115h. In this case, a height h21 of the cover portion 121 may be less than a height h22 of the accommodating portion 122. Alternatively, the cover portion 121 may have a height equal to the height h22 of the accommodating portion 122, and the engaging portion 123 may be omitted.

A first width W21 of the cover portion 121 described above may be greater than the first distance between the first parts 113a1 and 113b1, and may be equal to or less than the second distance between the second parts 113a2 and 113b2. A second width W22 of the accommodating portion 122 described above may be greater than the first distance d21 between the first parts 112a1 and 112b1, and may be equal to or less than the second distance d22 between the second parts 112a2 and 112b2. For example, the second width W22 may be equal to the first width W21.

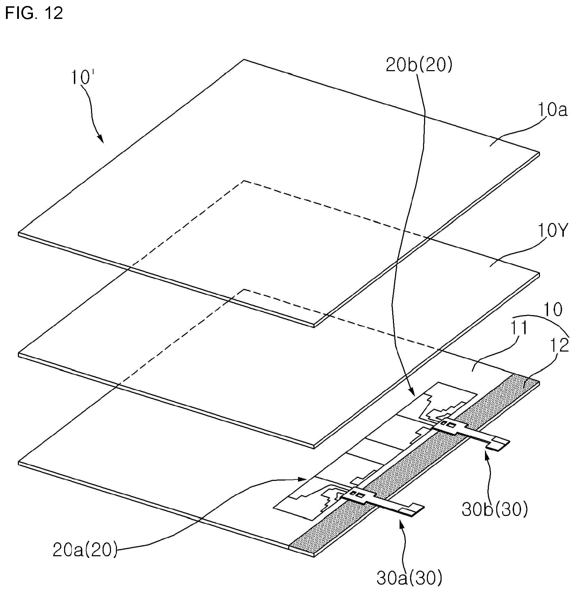

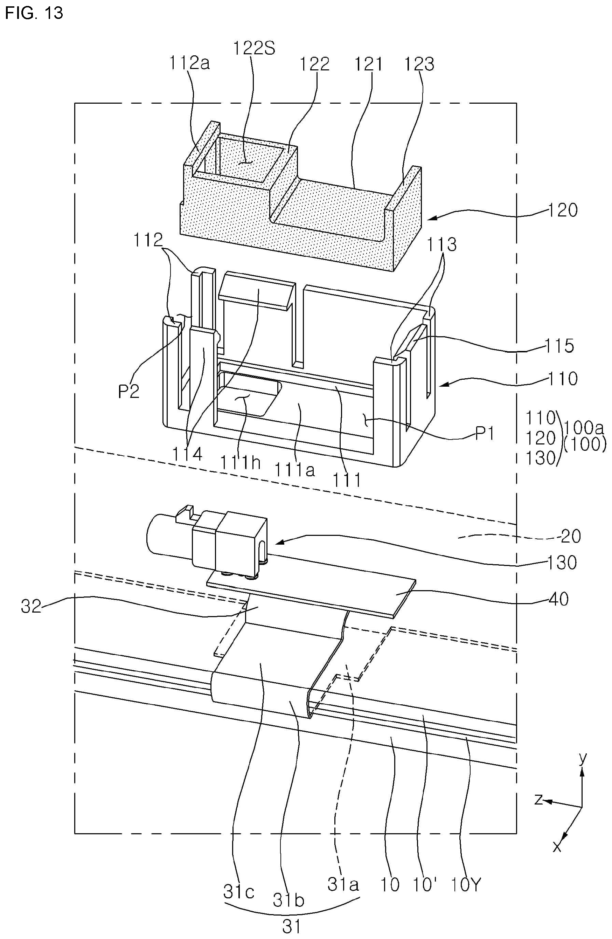

Referring to FIGS. 12 and 13, the glass 10' may include two sheets of glass 10 and 10a coupled or attached to each other, and an adhesive film 10Y sandwiched between the two sheets of glass 10 and 10a. For example, the adhesive film 10Y may be an anti-shatter film made of PVC (Poly Vinyl Chloride).

The antenna 20 may be positioned between the first glass 10 and the adhesive film 10Y or between the second glass 10a and the adhesive film 10Y so as to correspond to the transparent region 11. The connection module 100 may be coupled or attached on the glass 10' so as to correspond to the opaque region 12.

The connector 130 may be connected to the antenna 20 through the board 30. In this case, a portion of the board 30 may be disposed inside the glass 10', and another portion of the board 30 may be bent at one edge of the glass 10' to connect the portion of the board 30 and the connector 130.

The glass 10', the antenna 20, the board 30, a plate 40, and/or the connection module 100 may be collectively referred to as an antenna assembly, a com-

munication device, or an electronic device.

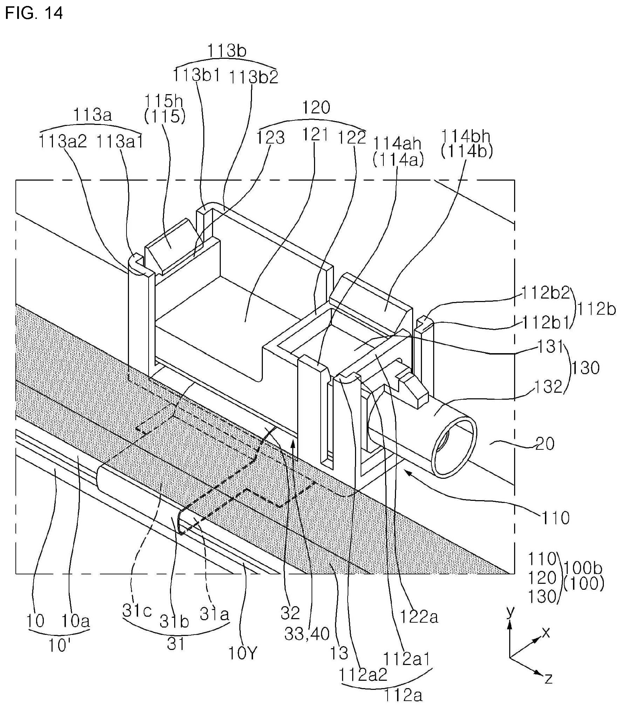

Referring to FIGS. 13 and 14, the antenna 20 may be coupled or attached in the transparent region 11 of the glass 10' through an adhesive member such as an optically clear adhesive film (OCA film). The lower housing 110 may be adjacent to the antenna 20, and may be coupled or attached on the opaque region of the glass 10' through an adhesive member such as a double-sided tape.

The board 30 may have one end connected to the antenna 20. A first part 31a of the board 30 may be positioned in the glass 10' at the same level as the antenna 20, and may define the one end of the board 30. A second part 31b of the board 30 may be connected to the first part 31a, and may cover a portion of a lateral side of the glass 10'. A third part 31c of the board 30 may be connected to the second part 31b, and may be positioned on the glass 10' at the same level as the lower housing 110. A fourth part 32 of the board 30 may be connected to the third part 31c, and may pass through the first opening P1 (see FIG. 13) and extend upward to the lower housing 110. A fifth part 33 of the board 30 may be connected to the fourth part 32, and may be seated on the flat surface portion 111a (see FIG. 13) of the base 111. The plate 40 may be positioned opposite the flat surface portion 111a with respect to the fifth part 33, and may be coupled or attached to the board 30.

Meanwhile, the second part 31b of the board 30 may be referred to as a bending portion 31b of the board 30. The bending portion 31b may be formed to be convex toward the outside (i.e., curved outward) of a lateral side of the glass 10'. Accordingly, the bending portion 31b may smoothly connect the first part 31a and the third part 31c. In this case, compared to a case in which a linear portion is arranged in an angled manner between the first part 31a and the third part 31c instead of the bending portion 31b, damage to the board 30 due to bending of the board 30 may be minimized.

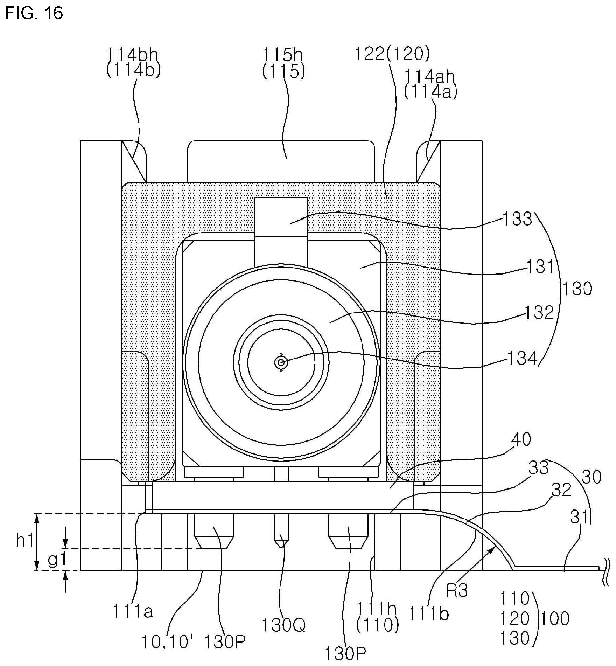

The connector 130 may be positioned opposite the fifth part 33 with respect to the plate 40, and may be seated on the plate 40 at a position adjacent to the front wall 112. Pins 130P and 130Q (see FIG. 16) may pass through the plate 40 and the fifth part 33 and be soldered to a lower surface of the board 30. A head 132 may extend from a body 131 toward the second opening P2 (see FIG. 13).

The upper housing 120 may be positioned opposite the plate 40 with respect to the connector 130. The plate 40 may contact a lower surface of the cover portion 121. The body 131 of the connector 130 may pass through the first hole 122h1 (see FIG. 11) of the accommodating portion 122 and be accommodated in the internal space 122S (see FIG. 13) of the accommodating portion 122. The head 132 of the connector 130 may pass through the second hole 122h2 (see FIG. 11) of the accommodating portion 122 and the second opening P2 of the lower housing 110. In addition, a stopper 122a, which is a portion of the accommodating portion 122, may define a portion of a boundary of the second hole 122h2, and one side of the connector 130 may be engaged with (or retained by) a lower end of the stopper 122a.

In this case, a front end of the upper housing 120 may be defined by the accommodating portion 122, and may be engaged with rear ends of the first parts 112a1 and 112b1. A rear end of the upper housing 120 may be defined by the cover portion 121, and may be engaged with front ends of the first parts 113a1 and 113b1. That is, the lower housing 110 may restrict forward and rearward movement of the upper housing 120 positioned inside the lower housing 110.

In addition, a right surface of the upper housing 120 may be engaged with the second parts 112a2 and 113a2 and the inner surface of the first side wall 114a. A left surface of the upper housing 120 may be engaged with the second parts 112b2 and 113b2 and the inner surface of the second side wall 114b. That is, the lower housing 110 may restrict left and right movement of the upper housing 120 positioned inside the lower housing 110.

Further, an upper end of the accommodating portion 122 may be engaged with lower ends of the side hooks 114ah and 114bh. An upper end of the engaging portion 123 may be engaged with a lower end of the central hook 115h. That is, the lower housing 110 may restrict vertical movement of the upper housing 120 positioned inside the lower housing 110.

Accordingly, the board 30, the plate 40, and the connector 130 may be positioned in place without shaking or wobbling between the lower housing 110 and the upper housing 120.

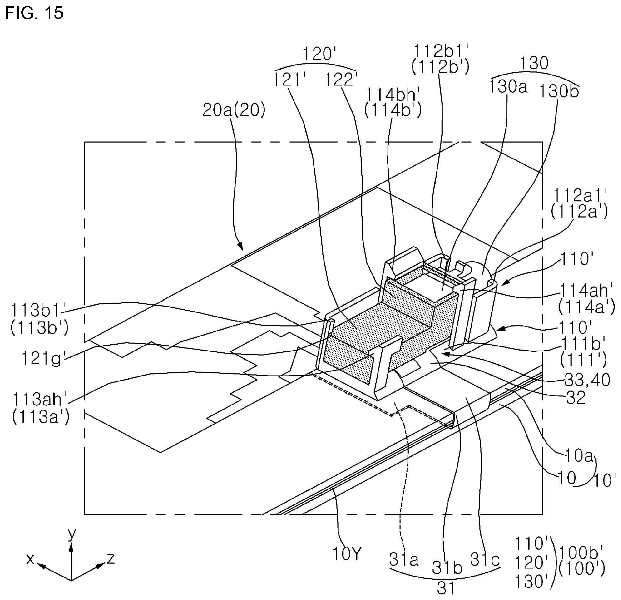

Referring to FIG. 15, a connection module 100' may include a housing (110', 120') instead of the housing (110, 120) described above with reference to FIGS. 13 and 14.

An upper housing 120' may include a cover portion 121' that covers the fifth part 33 of the board 30 and the plate 40, and an accommodating portion 122' that accommodates the connector 130.

In this case, a front end of the upper housing 120' may be defined by the accommodating portion 122', and may be engaged with rear ends of first parts 122a1' and 122b1' of a lower housing 110'. A rear end of the upper housing 120' may be defined by the cover portion 121', and a rear groove 121g' formed at the rear end of the upper housing 120' may be engaged with a front end of a first part 113b1'. That is, the lower housing 110' may restrict forward and rearward movement of the upper housing 120' positioned inside the lower housing 110'.

In addition, left and right surfaces of the upper housing 120' may be engaged with inner surfaces of walls 112a', 113a', and 114a' of the lower housing 110'. That is, the lower housing 110' may restrict left and right movement of the upper housing 120' positioned inside the lower housing 110'.

Further, an upper end of the accommodating portion 122' may be engaged with lower ends of side

hooks 114ah' and 114bh'. An upper end of the cover portion 121' may be engaged with a lower end of a rear hook 113ah'. That is, the lower housing 110' may restrict vertical movement of the upper housing 120' positioned inside the lower housing 110'.

Accordingly, the board 30, the plate 40, and the connector 130 may be positioned in place without shaking or wobbling between the lower housing 110' and the upper housing 120'.

Referring to FIG. 16, the pins 130P and 130Q may protrude from a lower surface of the body 131 of the connector 130 toward the hole 111h of the lower housing 110, and may pass through the plate 40 and the board 30. Holes 30Ph and 30Qh (see FIG. 12 and FIG. 15) and the hole 111h may be aligned vertically. Here, a portion of the board 30 overlapping the plate 40 may be referred to as a flat portion 33. For example, the flat portion 33 may be the fifth part 33 (see FIG. 13). Portions of the pins 130P and 130Q may be positioned inside the hole 111h, and may be spaced upward from an upper surface of the glass 10, 10' (see a gap g1 between the pins 130P, 130Q and the glass 10, 10').

Accordingly, the connection module 100 may be disposed in a flat manner on the glass 10, 10'.

The board 30 may include a connecting portion 31, a curved portion 32, and a flat portion 33. For example, the connecting portion 31 may be the first to third parts 31a, 31b, and 31c (see FIG. 13), the curved portion 32 may be the fourth part 32 (see FIG. 13), and the flat portion 33 may be the fifth part 33 (see FIG. 13).

At least a portion of the connecting portion 31 may be positioned on the glass 10, 10'. The flat portion 33 may overlap the plate 40, and may be seated on the flat surface portion 111a. The curved portion 32 may connect the connecting portion 31 and the flat portion 33, and may be positioned on a round portion 111b of the lower housing 110.

The round portion 111b may be a portion of the lower housing 110 that connects the first long side 111L1 of the lower housing 110 and the flat surface portion 111a, and may be formed between the first rear wall 113a and the first side wall 114a (see FIG. 11). A length L10 (see FIG. 11) of the round portion 111b may be equal to or greater than a width of the curved portion 32 (defined in a longitudinal direction of the round portion 111b). A surface of the round portion 111b may be a curved surface. The surface of the round portion 111b may be a convex curved surface with a predetermined radius of curvature R3. Alternatively, the surface of the round portion 111b may be a concave curved surface with a predetermined radius of curvature. The curved portion 32 may be curved along the surface of the round portion 111b, and may be seated on the surface of the round portion 111b.

Accordingly, despite a height difference (see h1) between the upper surface of the glass 10, 10' on which the connecting portion 31 is positioned and an upper surface of the flat surface portion 111a on which the flat portion 33 is positioned, the curved portion 32 may smoothly connect the connecting portion 31 and the flat portion 33. In this case, compared to a case in which a linear portion is provided instead of the round portion 111b, damage to the board 30 due to bending of the board 30 may be minimized.

Meanwhile, the antenna 20 may include a conductive material such as copper, gold, or silver. The antenna 20 may have an antenna pattern in the form of a metal mesh. The metal mesh may be a pattern in which electrodes are implemented by arranging a conductive material, such as copper, gold, or silver, in a grid pattern. The antenna pattern may be configured in a coplanar waveguide (CPW) structure. The CPW structure may have a structure in which a feed (or feeding) line connected to a radiation pattern and a ground pattern are positioned on the same plane and spaced apart from each other.

The antenna 20 may include a first layer 20M on which the metal mesh-type antenna pattern is formed, a second layer 20P made of a PET material for protecting an upper surface of the first layer 20M, and an adhesive member 20Y coupled to a lower surface of the first layer 20M and the upper surface of the glass 10, 10'.

The board 30 may include a first board layer 30a and/or a second board layer 30b. The first board layer 30a may be formed on one surface of the board 30, and the second board layer 30b may be formed on the other surface of the board 30. The first board layer 30a and the second board layer 30b may be electrically connected through a via.

The antenna 20 may be electrically connected to the cable C1, C2 (see FIG. 8) connected to the jack 134 of the connector 130 through the board 30 and the pins 130P and 130Q (see FIG. 12). That is, a component of the vehicle 1 (see FIG. 1) connected to the cable C1, C2 may perform communication using the antenna 20.

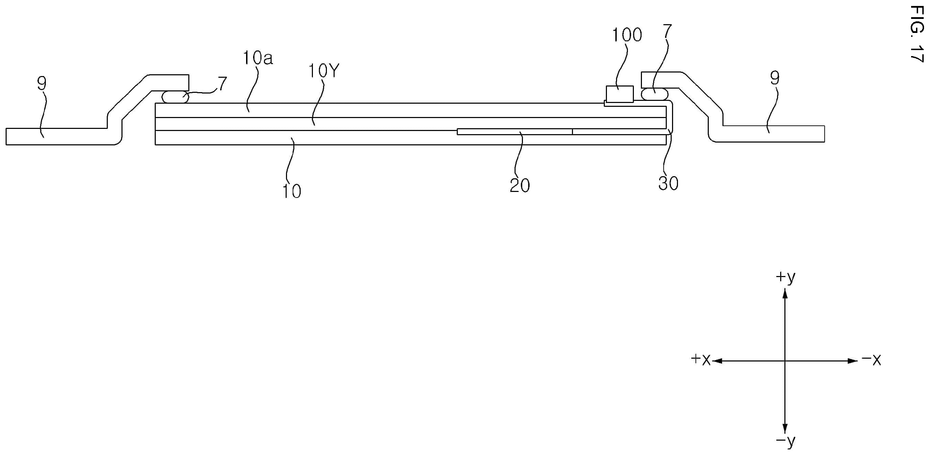

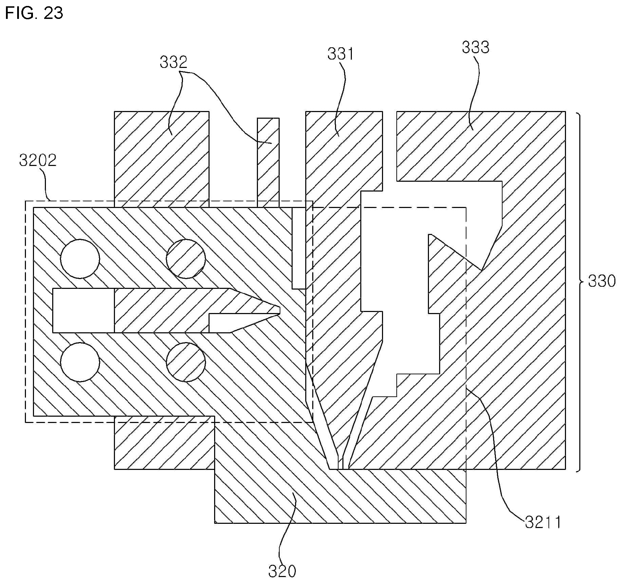

FIGS. 17 to 23 are diagrams for explaining a flexible printed circuit board and an antenna assembly, according to one embodiment of the present disclosure.

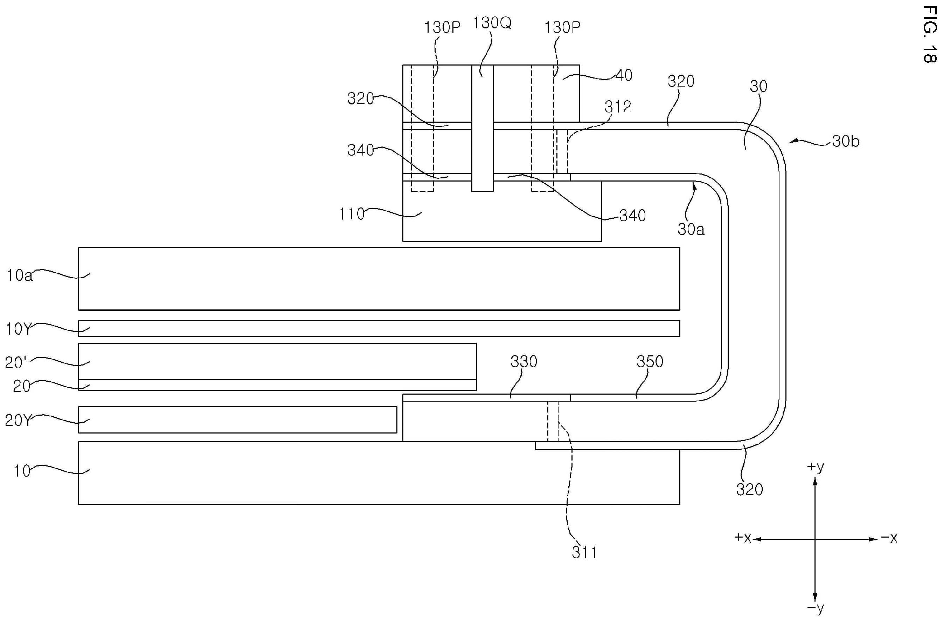

Referring to FIGS. 17 and 18, the antenna 20 may be disposed between the first glass 10 and the adhesive film 10Y. When the antenna 20 is disposed between the first glass 10 and the adhesive film 10Y, influence of the adhesive film 10Y and the like on signals transmitted and received through the antenna 20 may be minimized, compared to a case in which the antenna 20 is attached to the second glass 10a.

The first board layer 30a may include a first CPW pattern 330, a second CPW pattern 340, and a microstrip line 350. The microstrip line 350 may be referred to as a signal pattern 350, a third feed pattern 350, or the like.

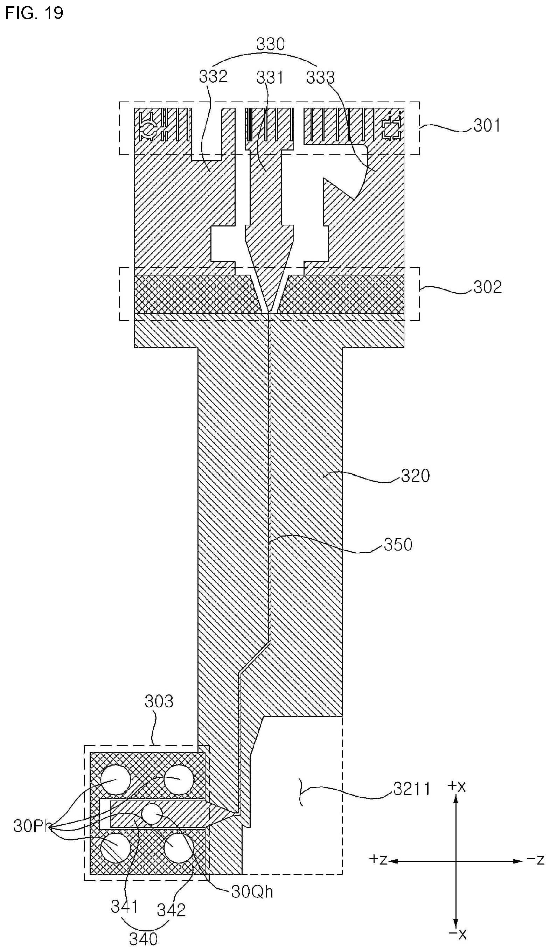

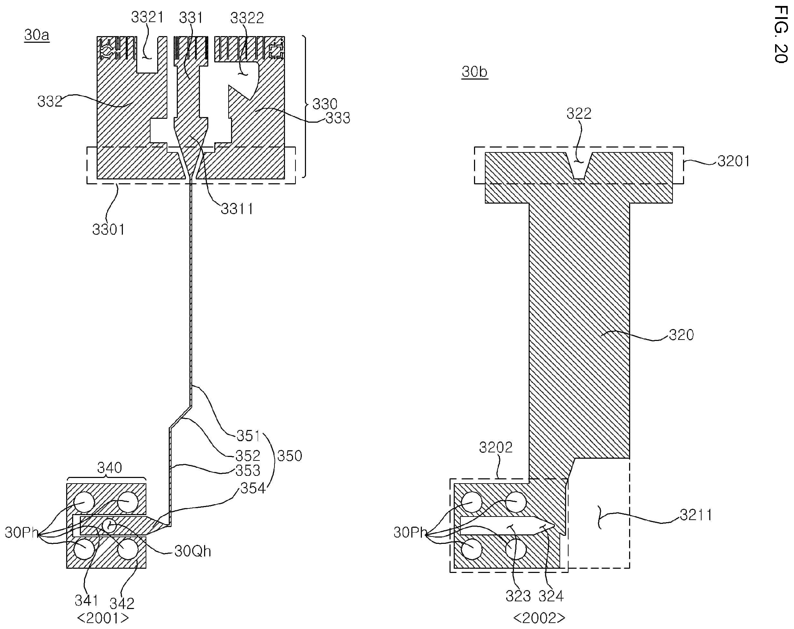

The first CPW pattern 330 may include a first feed pattern 331, a first ground pattern 332, and a second ground pattern 333 (see FIGS. 19 and 20). The first feed pattern 331 and the first and second ground patterns 332 and 333 may be electrically isolated from each other. The first CPW pattern 330 may be formed on the connecting

portion 31.

The second CPW pattern 340 may include a second feed pattern 341 and a third ground pattern 342 (see FIGS. 19 and 20). The second feed pattern 341 and the third ground pattern 342 may be electrically isolated from each other. The third ground pattern 342 may be formed to surround the second feed pattern 341. The third ground pattern 342 may be disposed on both sides of the second feed pattern 341. The third ground pattern 342 may include a plurality of ground patterns. The second CPW pattern 340 may be formed on the flat portion 33.

The microstrip line 350 may electrically connect the first feed pattern 331 of the first CPW pattern 330 and the second feed pattern 341 of the second CPW pattern 340. The microstrip line 350 may be formed on at least the connecting portion 31. The microstrip line 350 may be formed on the connecting portion 31, the curved portion 32, and the flat portion 33.

The second board layer 30b may include a fourth ground pattern 320. The fourth ground pattern 320 may be formed on at least the connecting portion 31. The fourth ground pattern 320 may be formed on the connecting portion 31, the curved portion 32, and the flat portion 33.

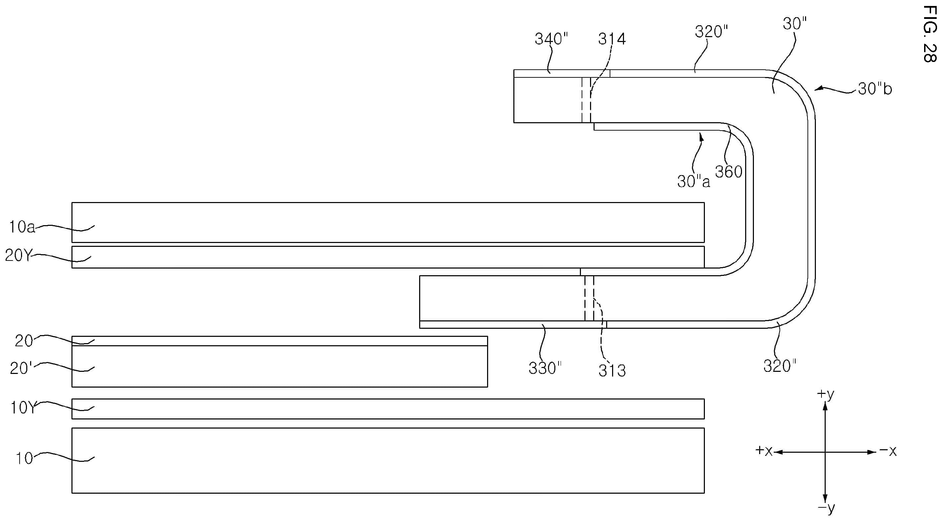

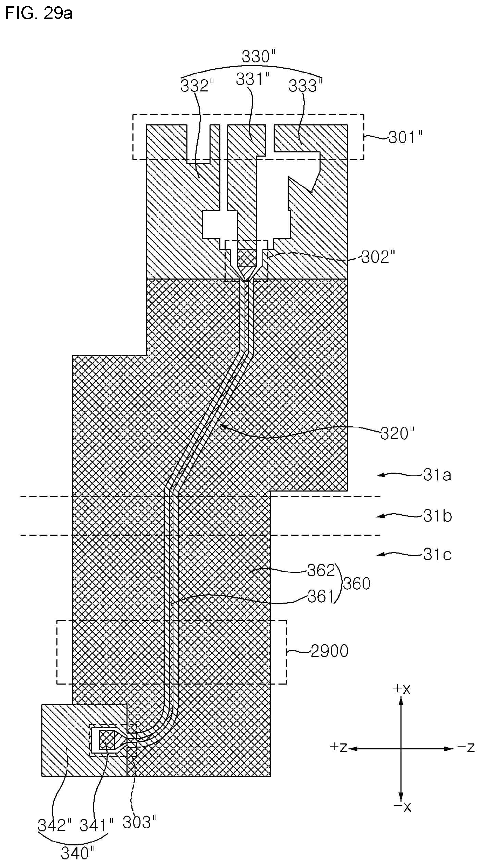

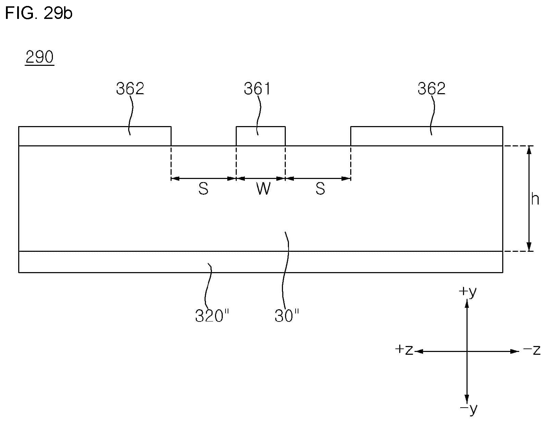

The second board layer 30b may be formed on the other surface of the board 30 facing the frame 9 of the vehicle 1. As the fourth ground pattern 320 is disposed on the second board layer 30b, it is possible to minimize influence of the frame 9 of the vehicle 1 made of a metallic material on the board 30 in relation to degradation of antenna impedance. That is, when only a CPW pattern is disposed on the first board layer 30a of the connecting portion 31, there is a disadvantage in that the influence of the frame 9 of the vehicle 1 on the board 30 cannot be blocked. In addition, when a GCPW structure in which a CPW pattern is disposed on the first board layer 30a of the connecting portion 31 and a ground pattern 320 is disposed on the second board layer 30b is formed on the connecting portion 31, the influence of the frame 9 of the vehicle 1 on the board 30 can be blocked. However, in order to form the GCPW structure, the width of a feed pattern needs to be extremely small, which causes a problem in that mass production is difficult. Therefore, according to one embodiment, the connecting portion 31 may be configured in a microstrip structure. Meanwhile, an example in which the connecting portion 31 is configured in the microstrip structure will be described below with reference to FIGS. 17 to 27, but the present disclosure is not limited thereto. For example, the connecting portion 31 may be formed in a GCPW structure. An example in which the connecting portion 31 is formed in the GCPW structure will be described below with reference to FIGS. 28 to 51.

The first ground pattern 332 and the second ground pattern 333 of the first CPW pattern 330 may be electrically connected to the fourth ground pattern 320. The fourth ground pattern 320 may be electrically connected to the first ground pattern 332 and the second ground pattern 333 of the first CPW pattern 330 through at least one first via 311.

The fourth ground pattern 320 may be electrically connected to the third ground pattern 342 of the second CPW pattern 340. The fourth ground pattern 320 may be electrically connected to the third ground pattern 342 of the second CPW pattern 340 through at least one second via 312.

A signal pin 130Q of the connector 130 passing through a signal pin hole 30Qh and a ground pin 130P passing through a ground pin hole 30Ph may be electrically connected to the other surface of the board 30. The signal pin 130Q and the ground pin 130P may be electrically connected to the other surface of the board 30 by soldering. The signal pin 130Q may be electrically connected to the second feed pattern 341 of the second CPW pattern 340. The ground pin 130P may be electrically connected to the third ground pattern 342 of the second CPW pattern 340.

The board 30 may include a first board portion on which the first CPW pattern 330 is formed, a second board portion on which the second CPW pattern 340 is formed, and a third board portion on which the microstrip line 350 and the fourth ground pattern 320 are formed.

Referring to FIGS. 19 and 20, one end 301 of the first CPW pattern 330 of the first board layer 30a may be connected to the antenna 20. The first CPW pattern 330 may be connected to the antenna 20 by applying a low-temperature bonding method. One end of the first feed pattern 331 of the first CPW pattern 330 may be connected to a feed line of the antenna pattern of the antenna 20. One end of the first ground pattern 332 and one end of the second ground pattern 333 of the first CPW pattern 330 may be respectively connected to a ground pattern of the antenna pattern of the antenna 20.

The first CPW pattern 330 may include at least one slit pattern. The slit pattern may refer to a pattern formed by a portion of an edge of a ground pattern being recessed inward. As an area of the slit pattern increases, an area of the ground pattern may decrease. The slit pattern may be formed at a predetermined position and in a predetermined shape to enhance antenna efficiency.

The first CPW pattern 330 may include a first slit pattern 3321 formed by a portion of an edge of the first ground pattern 332 being recessed inward. The first slit pattern 3321 may be formed such that a portion of an edge of the first ground pattern 332 adjacent to the antenna pattern of the antenna 20 is recessed along a -x-axis direction. The first slit pattern 3321 may be formed in a rectangular shape.

The first CPW pattern 330 may include a second slit pattern 3322 formed by a portion of an edge of the second ground pattern 333 being recessed inward. The second slit pattern 3322 may be formed such that a portion of an edge of the second ground pattern 333 adjacent to the first feed pattern 331 is recessed along a -z-axis direction. The second slit pattern 3322 may be

formed in a fan shape.

The other ends 3301 of the first and second ground patterns 332 and 333 of the first CPW pattern 330 may overlap one end 3201 of the fourth ground pattern 320 of the second board layer 30b. The other ends 3301 of the first and second ground patterns 332 and 333 may be electrically connected to the one end 3201 of the fourth ground pattern 320 through at least one second via 312.

The third ground pattern 342 of the second CPW pattern 340 of the first board layer 30a may overlap the other end 3202 of the fourth ground pattern 320 of the second board layer 30b. The other end 3202 of the fourth ground pattern 320 may be formed in a shape corresponding to the third ground pattern 342. A first slot 323, from which a pattern is removed to correspond to a shape of the second feed pattern 341 of the second CPW pattern 340, may be formed at the other end 3202 of the fourth ground pattern 320. An area of the first slot 323 may be greater than or equal to an area of the second feed pattern 341.

One end of the microstrip line 350 of the first board layer 30a may be connected to the first feed pattern 331 of the first CPW pattern 330. The other end of the microstrip line 350 may be connected to the second feed pattern 341 of the second CPW pattern 340.

The microstrip line 350 may include a first line portion 351, a second line portion 352, a third line portion 353, and/or an end portion 354. The end portion 354 of the microstrip line 350 may correspond to the other end of the microstrip line 350.

A second slot 324, from which a pattern is removed to correspond to a shape of the end portion 354 of the microstrip line 350 may be formed at the other end 3202 of the fourth ground pattern 320. An area of the second slot 324 may be greater than or equal to an area of the end portion 354 of the microstrip line 350.

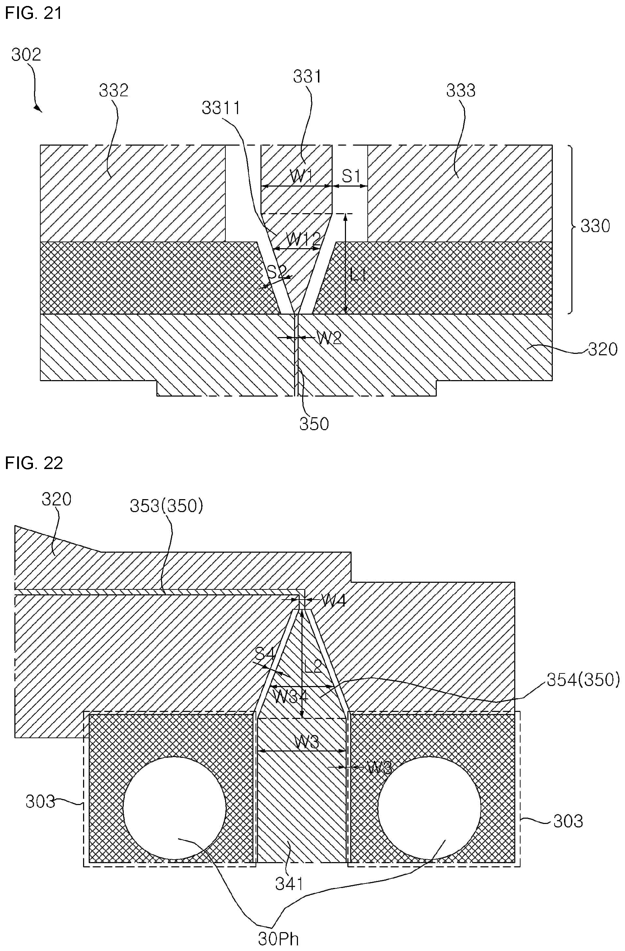

Referring to FIGS. 21 and 22, a first width w1 of the first feed pattern 331 of the first CPW pattern 330 and a first gap s1 between the first feed pattern 331 and the first and second ground patterns 332 and 333 may respectively have values corresponding to impedance matching with the antenna pattern. In the present disclosure, the antenna pattern is described as having an antenna impedance of 50 Ω.

Based on the first feed pattern 331 being disposed between the first glass 10 and the adhesive film 10Y, the first width w1 and the first gap s1 may respectively have values corresponding to a dielectric constant (εr) and a thickness of the first glass 10, and a dielectric constant (εr) and a thickness of at least one of the adhesive film 10Y and the second glass 10a.

A second width w2 of one end of the microstrip line 350 may be less than the first width w1 of the first feed pattern 331. The second width w2 of the one end of the microstrip line 350 may have a value corresponding to impedance matching with the antenna pattern. The second width w2 of the microstrip line 350 may have a value corresponding to a dielectric constant (εr) and a thickness of the board 30.

The width of the microstrip line 350, except for the end portion 354 connected to the second feed pattern 341 of the second CPW pattern 340, may be constant at the second width w2. The end portion 354 of the microstrip line 350 may be disposed on the flat portion 33. The remaining portion of the microstrip line 350, except for the end portion 354, may be disposed on at least the connecting portion 31.

A width w12 of the other end 3311 of the first feed pattern 331 may be less than the first width w1 and greater than the second width w2. The width w12 of the other end 3311 of the first feed pattern 331 may decrease toward the one end of the microstrip line 350. The other end 3311 of the first feed pattern 331 may be formed in a triangular shape. Accordingly, feed loss of the antenna 20 operating over a wideband may be reduced with respect to signal transmission between the CPW structure and the microstrip structure.

A first length L1 of the other end 3311 of the first feed pattern 331 may correspond to the first width w1. For example, the first length L1 of the other end 3311 of the first feed pattern 331 may have a value greater than the first width w1 by a predetermined ratio (e.g., 1.5 times).

A second gap s2 between the other end 3311 of the first feed pattern 331 and the first and second ground patterns 332 and 333 may be less than the first gap s1.

The one end 3201 of the fourth ground pattern 320 may include a third slit pattern 322 corresponding to a shape of the other end 3311 of the first feed pattern 331. The third slit pattern 322 may be formed such that a portion of an edge of the one end 3201 of the fourth ground pattern 320 is recessed inward. As the third slit pattern 322 is formed, overlapping between the one end 3201 of the fourth ground pattern 320 and the other end 3311 of the first feed pattern 331 may be prevented. That is, the third slit pattern 322 may serve as an element that reduces feed loss of the antenna 20 operating over a wideband.

Meanwhile, a third width w3 of the second feed pattern 341 of the second CPW pattern 340 and a third gap s3 between the second feed pattern 341 and the third ground pattern 342 may respectively have values corresponding to impedance matching with the antenna pattern. Based on the second CPW pattern 340 being disposed between the flat surface portion 111a of the lower housing 110 and the plate 40, the third width w3 and the third gap s3 may correspond to a dielectric constant (εr) and a thickness of each of the plate 40 and the lower housing 110.

The third width w3 of the second feed pattern 341 of the second CPW pattern 340 may be less than the first width w1 of the first feed pattern 331 of the first CPW pattern 330. The third gap s3 between the second feed pattern 341 and the third ground pattern 34 may be less than the first gap s1 between the first feed pattern 331 and the first and second ground patterns 332 and 333.

A width w4 of the third line portion 353 con-

nected to the end portion 354 of the microstrip line 350 may correspond to the second width w2. A width w34 of the other end 354 of the microstrip line 350 may be less than the third width w3 and greater than the fourth width w4. The width w34 of the other end 354 of the microstrip line 350 may increase toward the second feed pattern 341. The other end 354 of the microstrip line 350 may be formed in a triangular shape. Accordingly, feed loss of the antenna 20 operating over a wideband may be reduced with respect to signal transmission between the CPW structure and the microstrip structure.

A length L2 of the end portion 354 of the microstrip line 350 may correspond to the third width w3. For example, the length L2 of the end portion 354 of the microstrip line 350 may have a value greater than the first width w1 by a predetermined ratio (e.g., 1.2 times).

Referring to FIGS. 19, 20, and 23, when the board 30 is disposed such that the bending portion 31b is convex toward the outside of the lateral side of the glass 10', the board 30 may be formed in a shape that does not overlap the first feed pattern 331 of the connecting portion 31. That is, the flat portion 33 of the board 30 may be formed in a shape in which an overlapping region 3211 overlapping the first feed pattern 331 of the connecting portion 31 is removed. As the fourth ground pattern 320 of the second board layer 30b does not overlap the first feed pattern 331, degradation of radiation performance of the antenna 20 operating over a wideband may be prevented, thereby improving antenna efficiency.

Meanwhile, the first line portion 351 of the microstrip line 350 may extend from one end of the microstrip line 350 along an x-axis direction by a length sufficient to avoid the overlapping region 3211. The second line portion 352 may extend from an end of the first line portion 351 and bent by a predetermined angle in a +z-axis direction to avoid the overlapping region 3211. The third line portion 353 may extend from an end of the second line portion 352 along the x-axis direction by a length corresponding to a position of the second feed pattern 341 of the second CPW pattern 340. An end of the third line portion 353 may be connected to the end portion 354 of the microstrip line 350.

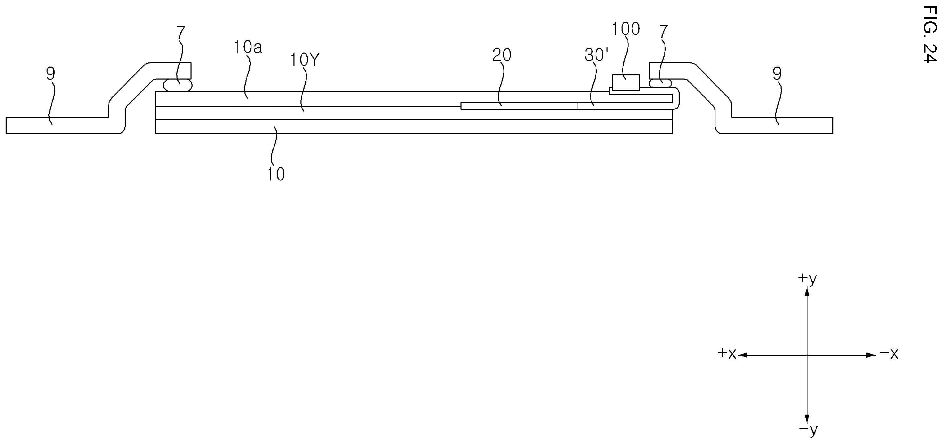

FIGS. 24 to 27 are diagrams for explaining a flexible printed circuit board and an antenna assembly, according to another embodiment of the present disclosure. Detailed descriptions identical to those given above with reference to FIGS. 17 to 23 will be omitted.

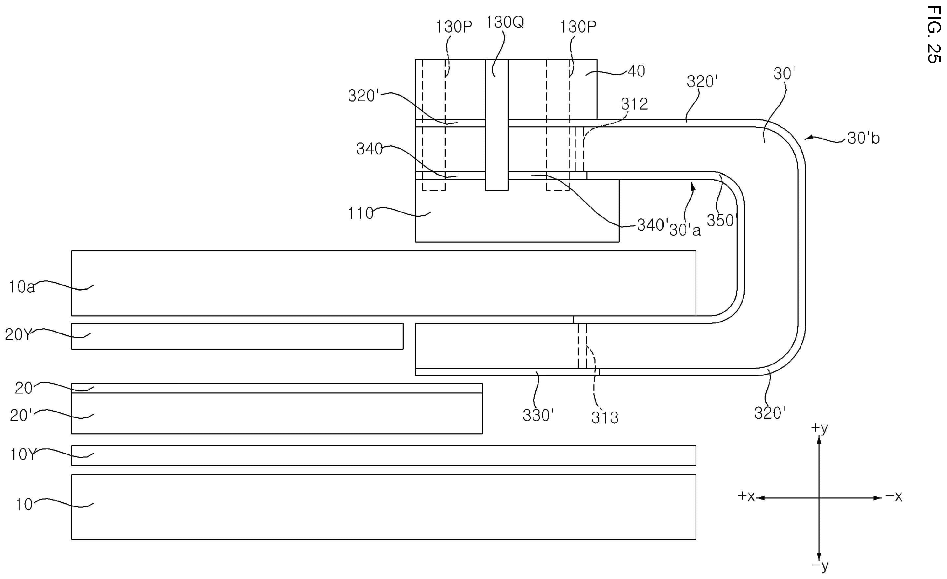

Referring to FIGS. 24 and 25, the antenna 20 may be disposed between the second glass 10a and the adhesive film 10Y. When the antenna 20 is disposed between the second glass 10a and the adhesive film 10Y, the influence of ultraviolet light or heat on the antenna 20 may be minimized by the adhesive film 10Y having a strong ultraviolet-blocking effect.

A first board layer 30'a may include a second CPW pattern 340' and a microstrip line 350'.

A second board layer 30'b may include a first CPW pattern 330' and a fourth ground pattern 320'. The fourth ground pattern 320' may be formed on at least the connecting portion 31. The fourth ground pattern 320' may be formed on the connecting portion 31, the curved portion 32, and the flat portion 33.

The microstrip line 350' may electrically connect a first feed pattern 331' of the first CPW pattern 330' and a second feed pattern 341' of the second CPW pattern 340'. The microstrip line 350' may be electrically connected to the first feed pattern 331' of the first CPW pattern 330' through at least one third via 313.

The first ground pattern 332' and the second ground pattern 333' of the first CPW pattern 330' may be electrically connected to the fourth ground pattern 320'. The first feed pattern 331' and the first and second ground patterns 332' and 333' may be electrically isolated from each other.

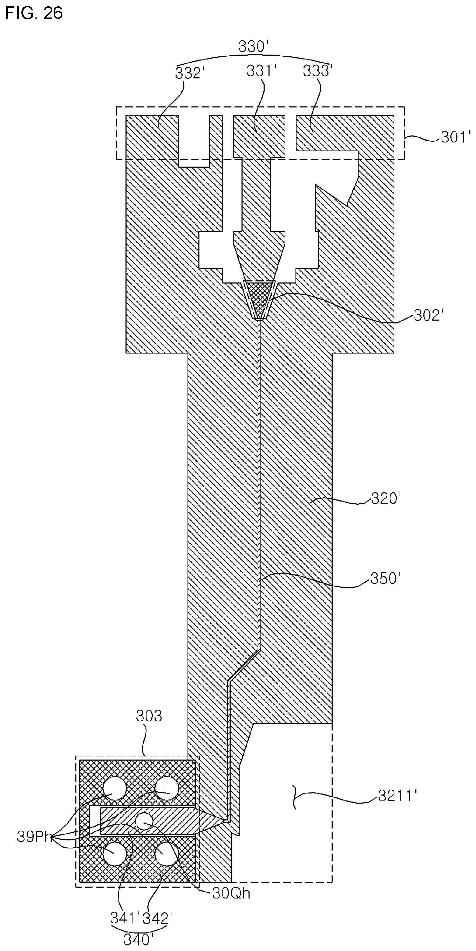

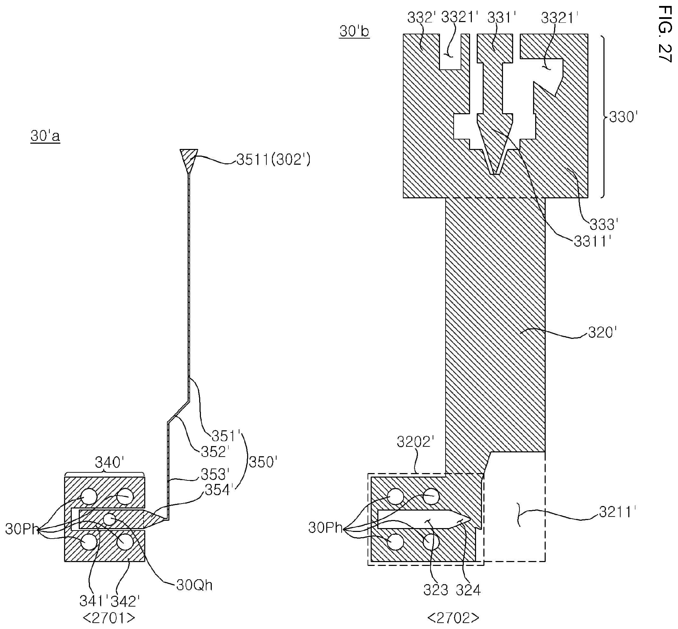

Referring to FIGS. 26 and 27, one end 301' of the first CPW pattern 330' of the second board layer 30'b may be connected to the antenna 20. One end of the first feed pattern 331' of the first CPW pattern 330' may be connected to a feed line of the antenna pattern of the antenna 20. One end of the first ground pattern 332' and one end of the second ground pattern 333' of the first CPW pattern 330' may be respectively connected to a ground pattern of the antenna pattern of the antenna 20.

The first CPW pattern 330' may include at least one slit pattern. The first CPW pattern 330' may include a first slit pattern 3321' formed by a portion of an edge of the first ground pattern 332' being recessed inward. The first CPW pattern 330' may include a second slit pattern 3322' formed by a portion of an edge of the second ground pattern 333' being recessed inward.

One end 302' of the microstrip line 350' of the first board layer 30'a may be connected to a first line portion 351' of the microstrip line 350. The one end 302' of the microstrip line 350' of the first board layer 30'a may overlap at least a portion of the other end 3311' of the first feed pattern 331' of the first CPW pattern 330' of the second board layer 30'b in a predetermined region 302'. The other end 3311' of the first feed pattern 331' may be electrically connected to the one end 302' of the microstrip line 350' through at least one third via 313.

A first width w1 of the first feed pattern 331' of the first CPW pattern 330' and a first gap s1 between the first feed pattern 331' and the first and second ground patterns 332' and 333' may respectively have values corresponding to impedance matching with the antenna pattern.

Based on the first feed pattern 331' being disposed between the second glass 10a and the adhesive film 10Y, the first width w1 and the first gap s1 may respectively have values corresponding to a dielectric constant ($\varepsilon r$) and a thickness of the second glass 10a, and a dielectric constant ($\varepsilon r$) and a thickness of at least one of the adhesive film 10Y and the first glass 10.

FIGS. 28 to 39 are diagrams for explaining a flexible printed circuit board and an antenna assembly, according to another embodiment of the present disclo-

sure. Detailed descriptions identical to those given above with reference to FIGS. 17 to 27 will be omitted.

Referring to FIGS. 28 to 29B, the antenna 20 may be disposed between the second glass 10a and the adhesive film 10Y.

A first board layer 30"a may include a third CPW pattern 360.

A second board layer 30"b may include a first CPW pattern 330", a fourth ground pattern 320", and a second CPW pattern 340". The fourth ground pattern 320" may be formed on at least the connecting portion 31. For example, an RF cable may be connected to the third CPW pattern 340" by soldering.

One end 301" of the first CPW pattern 330" of the second board layer 30"b may be connected to the antenna 20. One end of a first feed pattern 331" of the first CPW pattern 330" may be connected to a feed line of the antenna pattern of the antenna 20. One end of a first ground pattern 332" and one end of a second ground pattern 333" of the first CPW pattern 330" may be respectively connected to a ground pattern of the antenna pattern of the antenna 20.

A third feed pattern 361 of the third CPW pattern 360 may electrically connect the first feed pattern 331" of the first CPW pattern 330" and a second feed pattern 341" of the second CPW pattern 340".

The third feed pattern 361 of the third CPW pattern 360 and the first feed pattern 331" of the first CPW pattern 330" may overlap in a predetermined region 302". The third feed pattern 361 of the third CPW pattern 360 may be electrically connected to the first feed pattern 331" of the first CPW pattern 330" through at least one third via 313.

The third feed pattern 361 of the third CPW pattern 360 and the second feed pattern 341" of the second CPW pattern 340" may overlap in a predetermined region 303". The third feed pattern 361 may be electrically connected to the second feed pattern 341" of the second CPW pattern 340" through at least one fourth via 314.

The first ground pattern 332" and the second ground pattern 333" of the first CPW pattern 330" may be electrically connected to the fourth ground pattern 320". The first feed pattern 331" and the first and second ground patterns 332" and 333" may be electrically isolated from each other.

A third ground pattern 342" of the second CPW pattern 340" may be electrically connected to the fourth ground pattern 320". The second feed pattern 341" and the third ground pattern 342" may be electrically isolated from each other.

The fourth CPW pattern 360 and the fourth ground pattern 320" may constitute a pattern of a grounded co-planar waveguide (GCPW) structure. The GCPW structure may have a structure in which a third feed pattern 361 and a fifth ground pattern 362 are positioned spaced apart from each other on one surface, and a ground pattern 320" is positioned on the other surface.

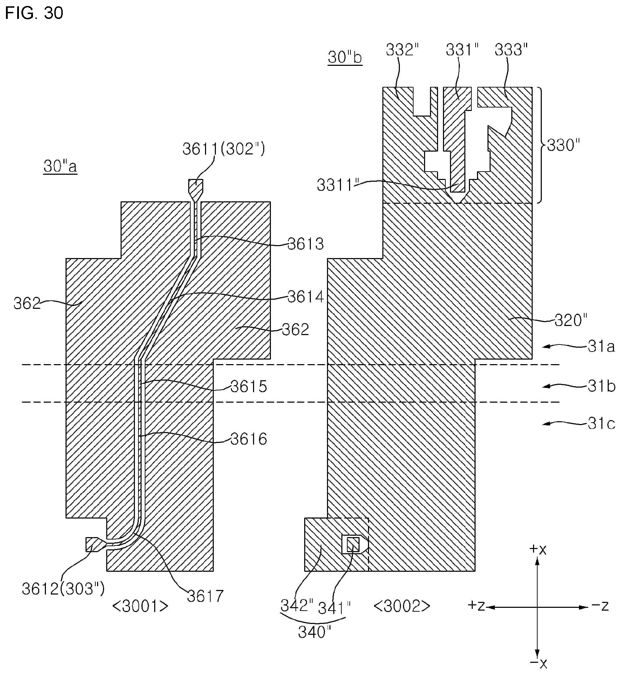

Referring to reference numeral 3001 of FIG. 30, the third CPW pattern 360 may be formed on the first board layer 30"a. The third CPW pattern 360 may include a third feed pattern 361 and a fifth ground pattern 362.

The third feed pattern 361 may include one end portion 3611 overlapping the first feed pattern 331" of the first CPW pattern 330", the other end portion 3612 overlapping the second feed pattern 341" of the second CPW pattern 340", a first line portion 3613 extending from the one end portion 3611 along a -x-axis direction, a second line portion 3614 extending from an end of the first line portion 3613 and bent by a predetermined angle in a +z-axis direction, a third line portion 3615 extending from an end of the second line portion 3614 along the -x-axis direction, a fourth line portion 3616 extending from an end of the third line portion 3615 along the -x-axis direction, and/or a fifth line portion 3617 connecting an end of the fourth line portion 3616 and the other end portion 3612.

The first line portion 3613 and the second line portion 3614 may be formed on the first part 31a (see FIG. 13) of the connecting portion 31 of the board 30. The first line portion 3613 and the second line portion 3614 may be referred to as a first feed part. The third line portion 3615 may be formed on the second part 31b (see FIG. 13) of the connecting portion 31 of the board 30. The third line portion 3615 may be referred to as a second feed part. The fourth line portion 3616 and the fifth line portion 3617 may be formed on the third part 31c (see FIG. 13) of the connecting portion 31 of the board 30. The fourth line portion 3616 and the fifth line portion 3617 may be referred to as a third feed part.

The fifth line portion 3617 may be formed in a curved shape so as to connect the end of the fourth line portion 3616 and the other end portion 3612.

Referring to reference numeral 3002 of FIG. 30, the first CPW pattern 330", the fourth ground pattern 320", and the second CPW pattern 340" may be formed on the second board layer 30"b.

The first feed pattern 331" of the first CPW pattern 330" may include an end portion 3311" overlapping the one end portion 3611 of the third feed pattern 361. The first ground pattern 332" and the second ground pattern 333" of the first CPW pattern 330" may be connected to the fourth ground pattern 320".

The second feed pattern 341" of the second CPW pattern 340" may overlap the other end portion 3612 of the third feed pattern 361. The third ground pattern 342" of the second CPW pattern 340" may be connected to the fourth ground pattern 320".

The fourth ground pattern 320" may be electrically connected to the fifth ground pattern 362 of the third CPW pattern 360. For example, the fourth ground pattern 320" and the fifth ground pattern 362 of the third CPW pattern 360 may be electrically connected to each other through at least one via.

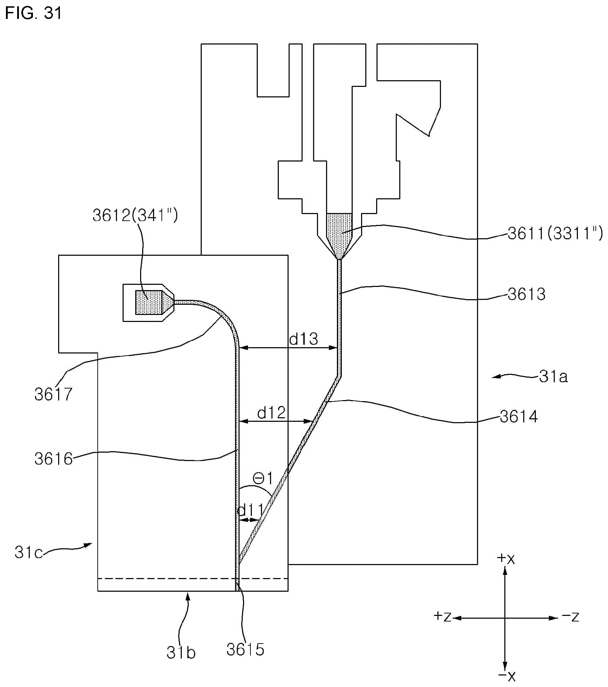

Referring to FIG. 31, when the board 30 is disposed in a bent manner such that the second part

31b of the board 30 is convex toward the outside of the lateral side of the glass 10', the first part 31a and the third part 31c of the board 30 may overlap each other. In this case, an angle formed by orthogonal projections of the second line portion 3614 formed on the first part 31a and the fourth line portion 3616 formed on the third part 31c onto the first part 31a may be a predetermined angle (Θ1). When the second line portion 3614 is formed by extending from an end of the first line portion 3613, the predetermined angle (Θ1) may correspond to an angle at which the second line portion 3614 is bent from the end of the first line portion 3613 in the +z-axis direction.

A gap in the z-axis direction between the orthogonal projections of the second line portion 3614 and the fourth line portion 3616 may increase as a distance from the third line portion 3615 increases. For example, the gap in the z-axis direction between the orthogonal projections of the second line portion 3614 and the fourth line portion 3616 may gradually increase to d11, d12, and d13 as the distance from the third line portion 3615 increases.

Meanwhile, a gap in the z-axis direction between an orthogonal projection of the fifth line portion 3617 onto the first part 31a and the first line portion 3613 may be greater than or equal to the gap in the z-axis direction between the orthogonal projections of the second line portion 3614 and the fourth line portion 3616. For example, the gap in the z-axis direction between the orthogonal projection of the fifth line portion 3617 and the first line portion 3613 may increase as the distance from the third line portion 3615 increases.

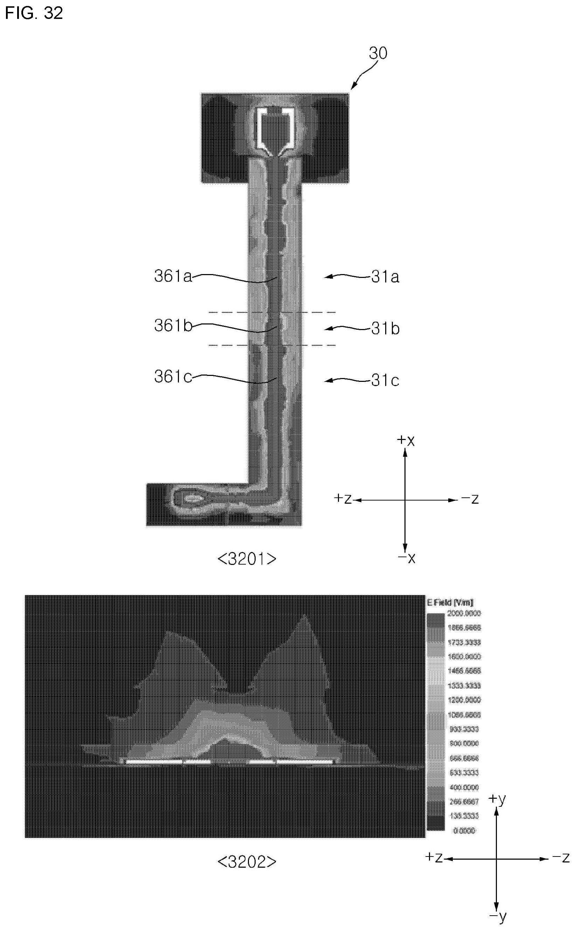

Referring to FIG. 32, when a signal is transmitted through the third feed pattern 361 of the third CPW pattern 360, an electric field (E-field) may be formed along the connecting portion 31 of the board 30. In this case, when the third feed pattern 361 of the third CPW pattern 360 is formed by extending along the x-axis direction, interference between portions of the third feed pattern 361 may be avoided when the board 30 is in a straight (i.e. unbent) state.

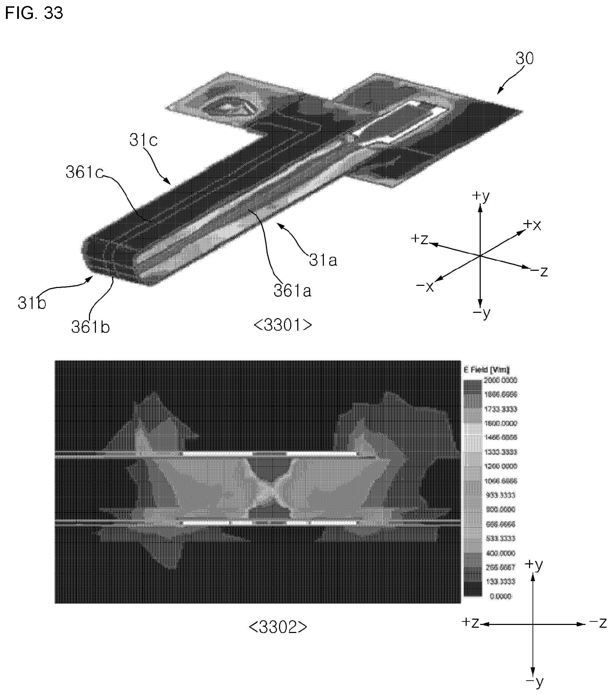

Meanwhile, referring to FIG. 33, in a case where the third feed pattern 361 of the third CPW pattern 360 is formed by extending along the x-axis direction, when the board 30 is disposed in a bent manner such that the second part 31b of the board 30 is convex toward the outside of the lateral side of the glass 10', a portion 361a of the third feed pattern 361 formed on the first part 31a of the board 30 and another portion 361c of the third feed pattern 361 formed on the third part 31c may overlap each other. In this case, feed loss may occur due to electric field interference occurring between the portion 361a and the portion 361c of the third feed pattern 361.

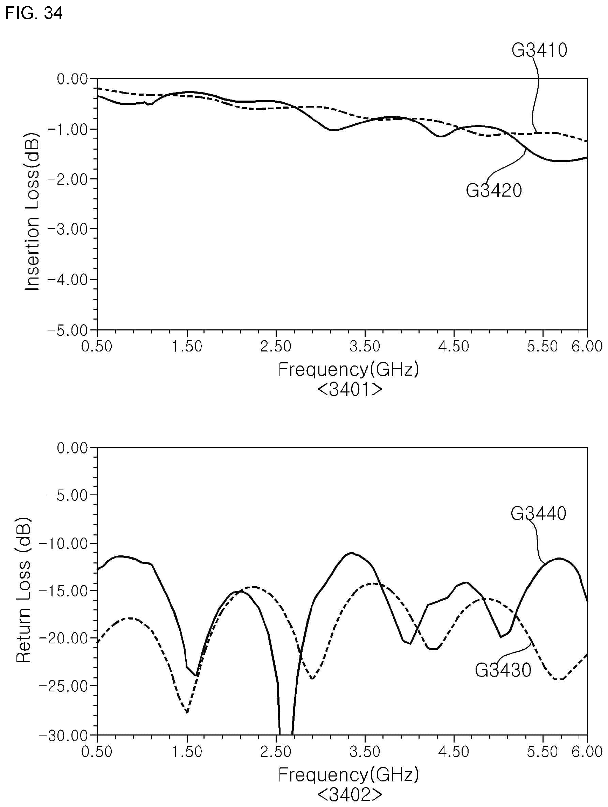

Referring to reference numeral 3401 of FIG. 34, insertion loss (G3410) when the board 30 is in a straight state as illustrated in FIG. 32 may be compared with insertion loss (G3420) when the board 30 is a bent state as illustrated in FIG. 33. In this case, since the insertion loss (G3410) in the straight state of the board 30 is closer to 0 dB than the insertion loss (G3420) in the bent state of the board 30, it can be confirmed that electric field interference generated between the portion 361a and the portion 361c of the third feed pattern 361 adversely affects the insertion loss.

Referring to reference numeral 3402 of FIG. 34, return loss (G3430) when the board 30 is in a straight state as illustrated in FIG. 32 may be compared with return loss (G3440) when the board 30 is in a bent state as illustrated in FIG. 33. In this case, since the return loss (G3430) in the straight state of the board 30 is farther from 0 dB than the return loss (G3440) in the bent state of the board 30, it can be confirmed that electric field interference generated between the portion 361a and the portion 361c of the third feed pattern 361 also adversely affects the return loss.

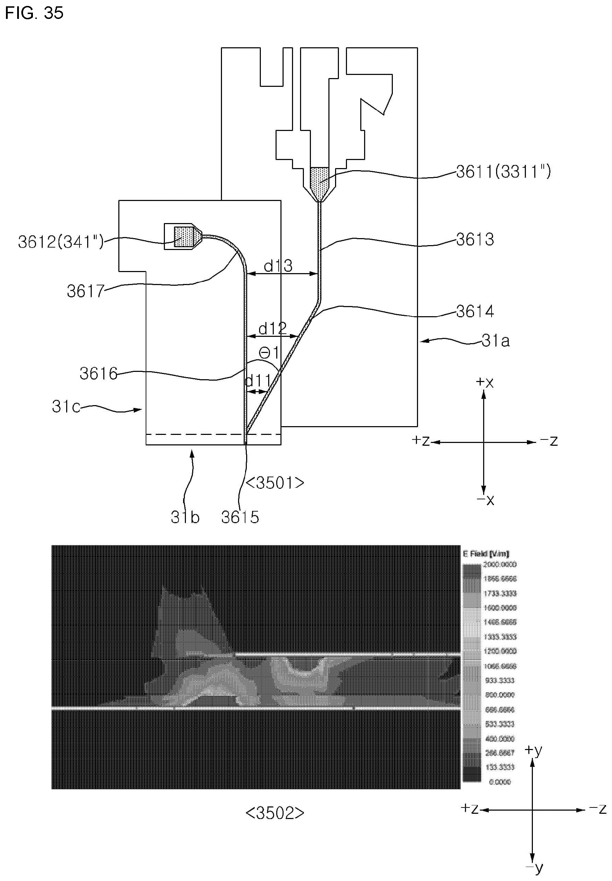

Meanwhile, referring to FIG. 35, when the third feed pattern 361 is formed such that orthogonal projections of the second line portion 3614 formed on the first part 31a and the fourth line portion 3616 formed on the third part 31c onto the first part 31a form a predetermined angle (Θ1), an overlapping region between the second line portion 3614 formed on the first part 31a and the fourth line portion 3616 formed on the third part 31c may be minimized even when the board 30 is disposed in a bent manner. In this case, even in the bent state of the board 30, feed loss due to electric field interference occurring between the second line portion 3614 and the fourth line portion 3616 may be minimized.

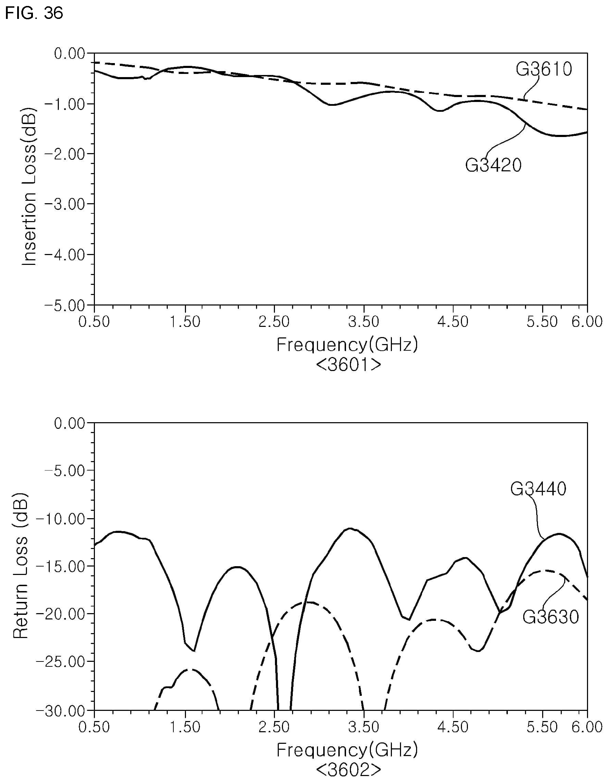

Referring to reference numeral 3601 of FIG. 36, insertion loss (3420) in a case where overlap of the third feed pattern 361 is large when the board 30 is in a bent state as illustrated in FIG. 33 may be compared with insertion loss (G3610) in a case where overlap of the third feed pattern 361 is minimized when the board 30 is in a bent state as illustrated in FIG. 35. In this case, since the insertion loss (G3610) in the case where the overlap of the third feed pattern 361 is minimized is closer to 0 dB than the insertion loss (3420) in the case where the overlap of the third feed pattern 361 is large, it can be confirmed that improvement is achieved in terms of insertion loss.

Referring to reference numeral 3602 of FIG. 36, return loss (3440) in a case where overlap of the third feed pattern 361 is large when the board 30 is in a bent state as illustrated in FIG. 33 may be compared with return loss (G3630) in a case where overlap of the third feed pattern 361 is minimized when the board 30 is in a bent state as illustrated in FIG. 35. In this case, since the return loss (G3630) in the case where the overlap of the third feed pattern 361 is minimized is farther from 0 dB than the return loss (3440) in the case where the overlap of the third feed pattern 361 is large, it can be confirmed that improvement is also achieved in terms of return loss.

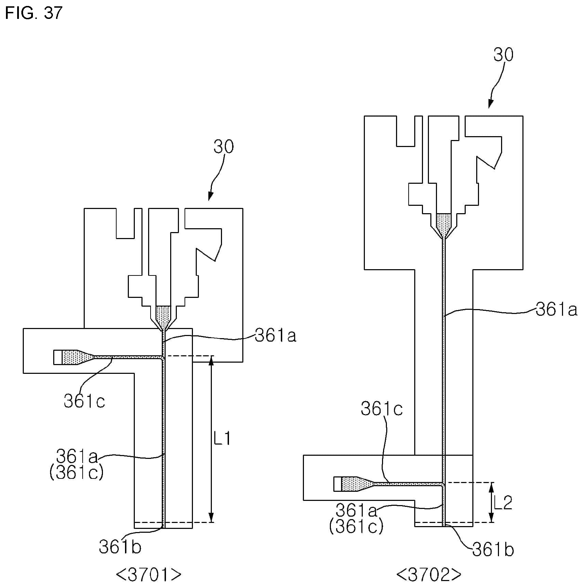

Meanwhile, referring to FIG. 37, when the board 30 is disposed in a bent manner such that the second part 31b of the board 30 is convex toward the outside of the lateral side of the glass 10', feed loss due to electric field interference may decrease as an area in which the por-

tion 361a and the portion 361c of the third feed pattern 361 overlap decreases.

For example, when the length of the overlapping region between the portion 361a and the portion 361c of the third feed pattern 361 is L1, feed loss may be greater than when the length of the overlapping region between the portion 361a and the portion 361c of the third feed pattern 361 is L2.

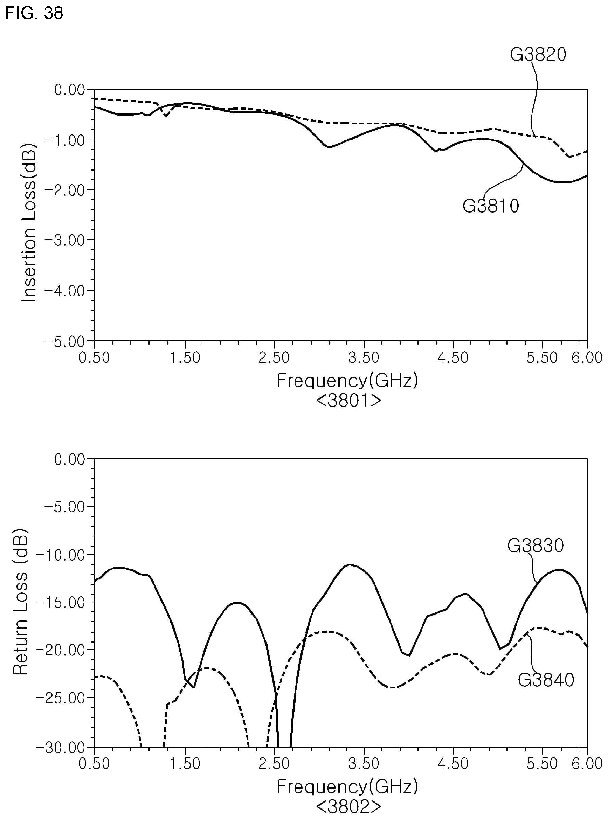

Referring to reference numeral 3801 of FIG. 38, insertion loss (G3810) in a case where the length of the overlapping region in the third feed pattern 361 is L1, as illustrated by reference numeral 3701 of FIG. 37, may be compared with insertion loss (G3820) in a case where the length of the overlapping region in the third feed pattern 361 is L2, as illustrated by reference numeral 3702 of FIG. 37. In this case, since the insertion loss (G3820) in the case where the length of the overlapping region in the third feed pattern 361 is L2 is closer to 0 dB than the insertion loss (G3810) in the case where the length of the overlapping region in the third feed pattern 36 is L1, it can be confirmed that influence of electric field interference on the insertion loss is reduced as the length of the overlapping region decreases.

Referring to reference numeral 3802 of FIG. 38, return loss (G3830) in a case where the length of the overlapping region in the third feed pattern 361 is L1, as illustrated by reference numeral 3701 of FIG. 37, may be compared with return loss (G3840) in a case where the length of the overlapping region in the third feed pattern 361 is L2, as illustrated by reference numeral 3702 of FIG. 37. In this case, since the return loss (G3840) in the case where the length of the overlapping region in the third feed pattern 361 is L2 is farther from 0 dB than the return loss (G3830) in the case where the length of the overlapping region in the third feed pattern 361 is L1, it can be confirmed that influence of electric field interference on the return loss is reduced as the length of the overlapping region in the feed pattern 361 decreases.

In this case, a maximum value of the length of the overlapping region between the portion 361a and the portion 361c of the third feed pattern 351 for reducing feed loss may correspond to a frequency used for communication through the antenna 20. For example, the maximum value of the length of the overlapping region in the third feed pattern 351 may be determined based on Equation 1 below.

【Equation 1】

$$Zo = \frac{60.0\pi}{\sqrt{\varepsilon_{eff}}} \cdot \frac{1.0}{\frac{K(k)}{K(k')} + \frac{K(k1)}{K(k1')}}$$

$$k = \frac{a}{b}$$

$$k' = \sqrt{1.0 - k^2}$$

$$k1' = \sqrt{1.0 - k1^2}$$

$$k1 = \frac{\tanh\left(\frac{\pi a}{4.0 h}\right)}{\tanh\left(\frac{\pi b}{4.0 h}\right)}$$

$$\varepsilon_{eff} = \frac{1.0 + \varepsilon_r \frac{K(k')}{K(k)} \frac{K(k1)}{K(k1')}}{1.0 + \frac{K(k')}{K(k)} \frac{K(k1)}{K(k1')}}$$

Here, a denotes a width (w) of the third feed pattern 361, and b denotes a gap between the fifth ground patterns 362, i.e., a sum of the width (w) of the third feed pattern 361 and gaps (s) between the third feed pattern 361 and the fifth ground patterns 362. For example, when the width (w) of the third feed pattern 361 is 0.3 mm, the gap (s) between the third feed pattern 361 and the fifth ground pattern 362 is 0.6 mm, a dielectric constant ($\varepsilon r$) of the second glass 10a is 6.5, a thickness of the board 30 is 0.2 mm, and a frequency is 6 GHz, an impedance may be calculated as 50 Ω, an effective dielectric constant ($\varepsilon eff$) may be calculated as 4.8, and a guided wavelength ($\lambda g$) may be calculated as 22.8 mm. In this case, the maximum value of the length of the overlapping region in the third feed pattern 361 may be calculated as 5.7 mm, which is $\lambda g/4$.

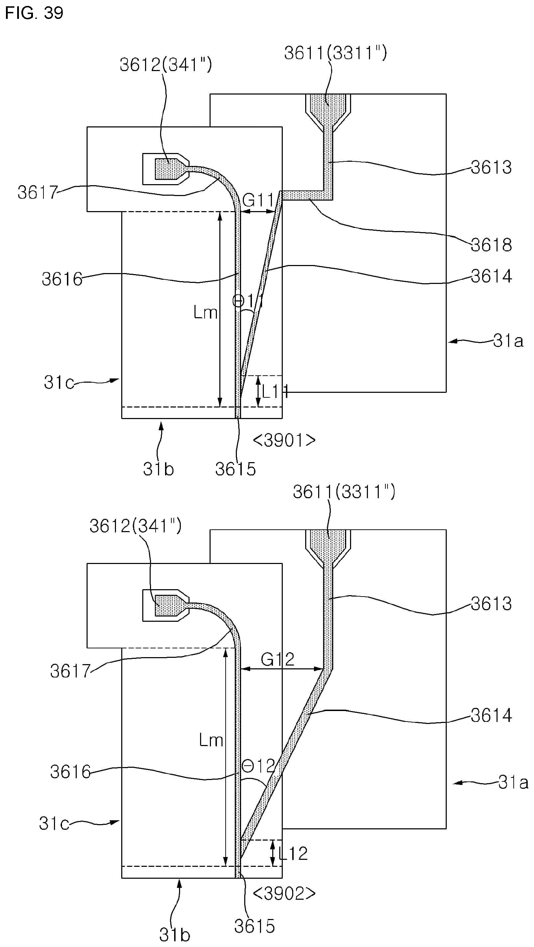

Meanwhile, referring to FIG. 39, in order to minimize feed loss, it is necessary to minimize not only the length of the overlapping region in the third feed pattern 361 but also an overall length of the third feed pattern 361. In consideration of this, the first line portion 3613 and the third line portion 3615 of the third feed pattern 361 may be configured as straight lines with respect to the x-axis direction. In addition, an angle formed by orthogonal projections of the second line portion 3614 formed on the first part 31a and the fourth line portion 3616 formed on the third part 31c onto the first part 31a may be determined based on the length of the overlapping region in the third feed pattern 361. For example, the angle formed by the orthogonal projections of the second line portion 3614 formed on the first part 31a and the fourth line portion 3616 formed on the third part 31c onto the first part 31a may be determined based on Equation 2 below.

【Equation 2】

$$L = \frac{s + w}{\tan\theta} < \frac{1}{4}\lambda_g$$

$$\tan\theta = \frac{s + w}{L}$$

Here, L denotes a length of the overlapping region in the third feed pattern 361, w denotes a width (w) of the third feed pattern 361, and s denotes a gap (s) between the third feed pattern 361 and the fifth ground pattern 362.

For example, as shown by reference numeral 3901, when the width (w) of the third feed pattern 361 is 0.3 mm, the gap (s) between the third feed pattern 361 and the fifth ground pattern 362 is 0.6 mm, and a length L11 of the overlapping region in the third feed pattern 361 is 5.7 mm, an angle (Θ11) formed by orthogonal projections of the second line portion 3614 formed on the first part 31a and the fourth line portion 3616 formed on the third part 31c onto the first part 31a may be 9°. In this case, the third feed pattern 361 may further include a sixth line portion 3618 connecting the first line portion 3613 and the second line portion 3614.

For example, as shown by reference numeral 3902, when the width (w) of the third feed pattern 361 is 0.3 mm, the gap (s) between the third feed pattern 361 and the fifth ground pattern 362 is 0.6 mm, and the length L11 of the overlapping region in the third feed pattern 361 is 1.6 mm, an angle (Θ12) formed by orthogonal projections of the second line portion 3614 formed on the first part 31a and the fourth line portion 3616 formed on the third part 31c onto the first part 31a may be 30°. In this case, when the angle formed by the orthogonal projections of the second line portion 3614 formed on the first part 31a and the fourth line portion 3616 formed on the third part 31c onto the first part 31a exceeds 30°, feed loss may increase as the overall length of the third feed pattern 361 increases.

Accordingly, the angle formed by the orthogonal projections of the second line portion 3614 formed on the first part 31a and the fourth line portion 3616 formed on the third part 31c onto the first part 31a may be set within a predetermined angle range determined based on a first angle corresponding to the maximum value of the length of the overlapping region in the third feed pattern 361 and a second angle corresponding to an increase in the overall length of the third feed pattern 361.

Meanwhile, a length Lm of the fourth line portion 3616 formed on the third part 31c may correspond to a width of a region corresponding to the packing member 13 and/or the frame 9.

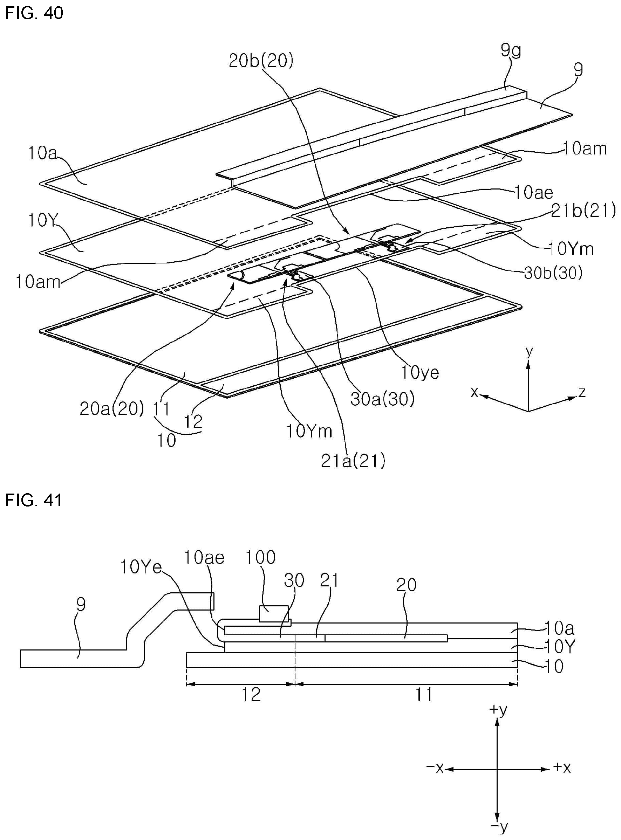

FIGS. 40 to 51 are diagrams for explaining a flexible printed circuit board and antenna assembly, according to another embodiment of the present disclosure.

Referring to FIGS. 40 and 41, one region 10ae of a lateral side of the second glass 10a adjacent to the frame 9 of the vehicle 1 may be positioned inside the second glass 10a so as not to overlap the groove 9g of the frame 9. In this case, the remaining region of the lateral side of the second glass 10a, except for the one region 10ae, may overlap the groove 9g of the frame 9. A sealant 7 may be filled between a predetermined region 10am of the second glass 10a corresponding to the remaining region of the lateral side of the second glass 10a, except for the one region 10ae, and the groove 9g of the frame 9.

A shape of the adhesive film 10Y may correspond to a shape of the second glass 10a. One region 10Ye of a lateral side of the adhesive film 10Y adjacent to the frame 9 of the vehicle 1 may be positioned inside the adhesive film 10Y so as not to overlap the groove 9g of the frame 9. In this case, the remaining region of the lateral side of the adhesive film 10Y, except for the one region 10Ye, may overlap the groove 9g of the frame 9. A predetermined region 10Ym of the adhesive film 10Y corresponding to the remaining region of the lateral side of the adhesive film 10Y, except for the one region 10Ye, may overlap the predetermined region 10am of the second glass 10a.

The bending portion 31b of the connecting portion 31 of the board 30 may be formed to convex toward the outside of the one region 10ae of the lateral side of the second glass 10a. In this case, as the one region 10ae of the lateral side of the second glass 10a is positioned inside the second glass 10a without overlapping the groove 9g of the frame 9, influence of the frame 9 of the vehicle 1 made of a metallic material on the board 30, in relation to degradation of antenna impedance, may be significantly reduced.

The antenna 20 may be disposed between the second glass 10a and the adhesive film 10Y corresponding to the transparent region 11. A sub-antenna 21 may be connected to the antenna 20. The sub-antenna 21 may be positioned between the second glass 10a and the adhesive film 10Y corresponding to the transparent region 11. The sub-antenna 21 may be connected to the board 30. The antenna 20 connected to the sub-antenna 21 may be referred to as a main antenna.

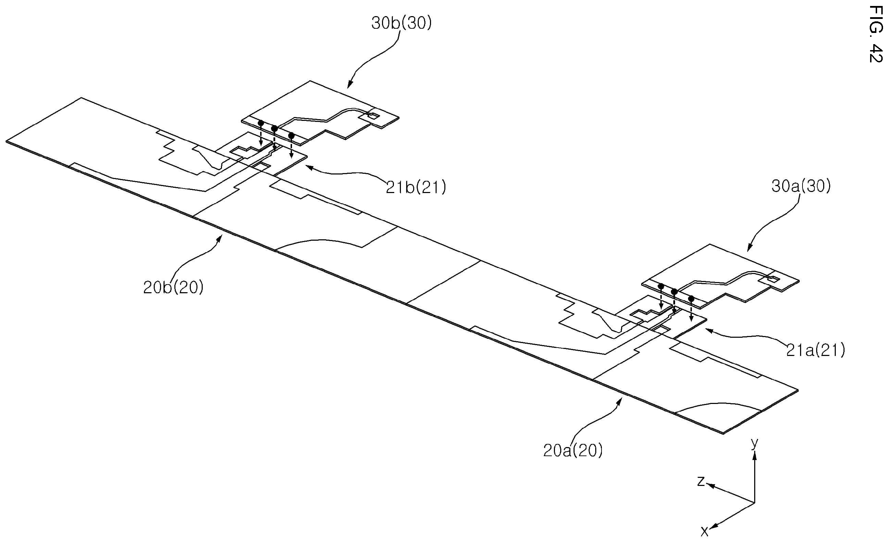

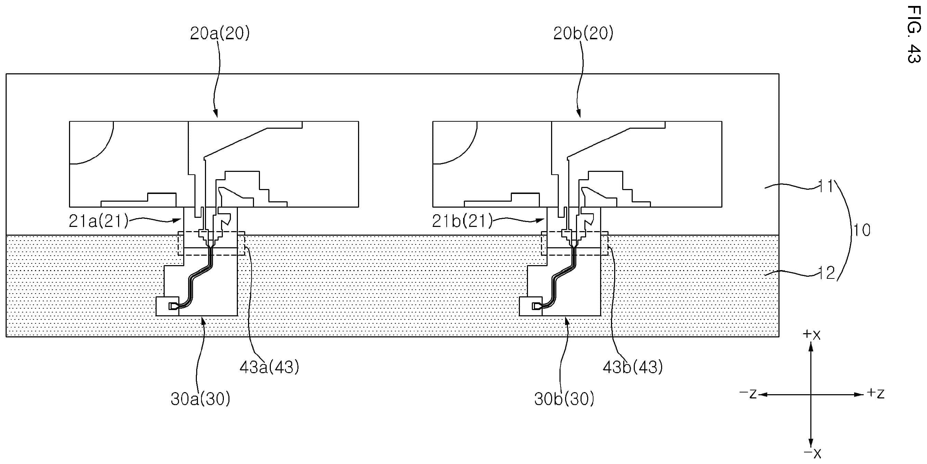

Referring to FIGS. 42 and 43, a first sub-antenna 21a may be connected to a first main antenna 20a. A second sub-antenna 21b may be connected to a second main antenna 20b.

The sub-antenna 21 may be transparent. The sub-antenna 21 may be implemented by forming an antenna pattern on a substrate made of a transparent material. The sub-antenna 21 may be flexible.

The sub antenna 21 may include a sub-feed line connected to a main feed line of the antenna pattern of the main antenna 20. The sub-antenna 21 may include a sub-ground pattern connected to a main ground pattern of the antenna pattern of the main antenna 20. The sub-feed line of the sub-antenna 21 may be electrically isolated

from the sub-ground pattern of the sub-antenna 21.

The sub-antenna 21 may have a shape corresponding to the shape of the first CPW pattern 330, 330'. For example, the sub-feed line of the sub-antenna 21 may have a shape corresponding to the shape of the first feed pattern 331, 331' of the first CPW pattern 330, 330'. For example, the sub-ground line of the sub-antenna 21 may have a shape corresponding to the shape of the second ground pattern 332, 332' and/or the third ground pattern 333, 333' of the first CPW pattern 330, 330'. Meanwhile, the sub-antenna 21 may include at least one slit pattern included in the first CPW pattern 330, 330'.

The sub-antenna 21 may be connected to the board 30 in the opaque region 12. One end of the sub-antenna 21 may overlap one end of the board 30 in a predetermined region 43 of the opaque region 12.

A signal in a first frequency band may be transmitted and received through the main antenna 20. A signal in a second frequency band may be transmitted and received through the sub-antenna 21. For example, the first frequency band may be from 0.6 GHz to 4.5 GHz, and the second frequency band may be from 5 GHz to 6 GHz.

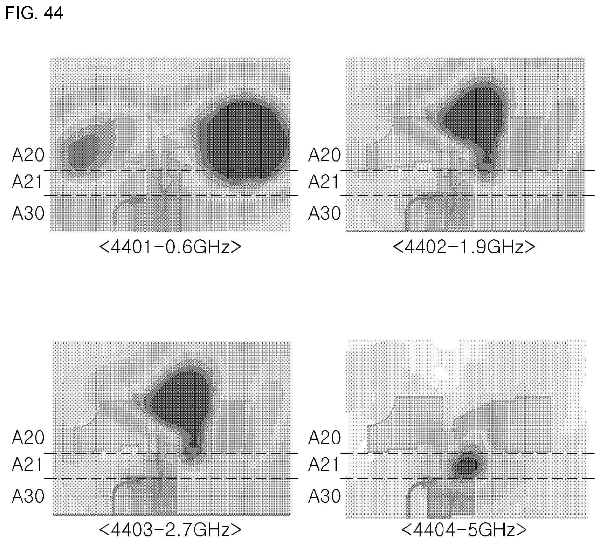

Referring to FIG. 44, a 0.6 GHz signal may be transmitted and received through a first signal region A20 corresponding to the main antenna 20 (4401). In addition, a 1.9 GHz signal and a 2.7 GHz signal may also be transmitted and received through the first signal region A20 corresponding to the main antenna 20 (4402, 4403). Meanwhile, a 5 GHz signal may be transmitted and received through a second signal region A21 corresponding to the sub-antenna 21 (4404).

Meanwhile, transparency of the main antenna 20 and transparency of the sub-antenna 21 may be different from each other. Sheet resistance of the main antenna 20 and sheet resistance of the sub-antenna 21 may be different from each other. For example, the transparency of the sub-antenna 21 may be lower than the transparency of the main antenna 20, and the sheet resistance of the sub-antenna 21 may be smaller than the sheet resistance of the main antenna 20.

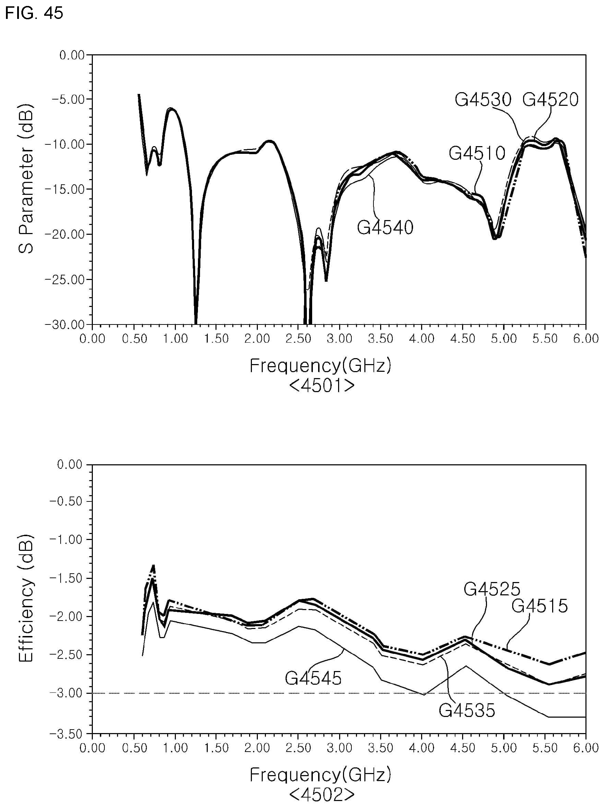

Referring to reference numeral 4501 of FIG. 45, S-parameter characteristics may be similar to each other in all cases where the sub-antenna 21 is formed of the board 30 (G4510), where the sheet resistance of the sub-antenna 21 is 0.05Ω (G4520), where the sheet resistance of the sub-antenna 21 is 0.15Ω (G4530), and where the sheet resistance of the sub-antenna 21 is 0.5Ω (G4540). That is, even when the transparency and sheet resistance of the sub-antenna 21 are different, the S-parameter characteristics may be maintained.

Meanwhile, referring to reference numeral 4502 of FIG. 45, the antenna efficiency according to the sheet resistance of the sub-antenna 21 may be compared. Here, the antenna efficiency may be expressed in decibels (dB) corresponding to antenna gain.

In the case where the sub-antenna 21 is formed of the board 30 (G4510), in the case where the sheet resistance of the sub-antenna 21 is 0.05Ω (G4520), and in the case where the sheet resistance of the sub-antenna 21 is 0.15Ω (G4530), the antenna efficiency may satisfy a target value of -3dB. By contrast, in the case where the sheet resistance of the sub-antenna 21 is 0.5Ω (G4540), the antenna efficiency may not satisfy the target value of -3dB in a frequency band of 5GHz or higher. Therefore, the sub-antenna 21 may be configured to have a sheet resistance of 0.15Ω or less. For example, the main antenna 20 may have a sheet resistance of 0.5Ω or less, and the sub-antenna 21 may have a sheet resistance of 0.15Ω or less.

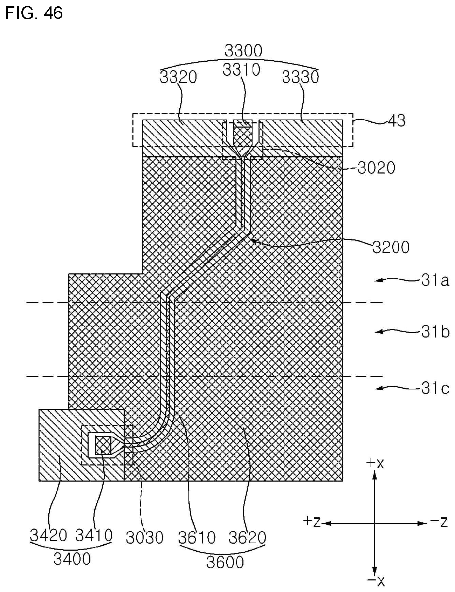

FIGS. 46 to 51 are diagrams for explaining a board according to various embodiments of the present disclosure. Detailed descriptions identical to those given above with reference to FIGS. 28 to 39 will be omitted.

Referring to FIG. 46, a first board layer 300a may include a third CPW pattern 3600.

A second board layer 300b may include a first CPW pattern 3300, a fourth ground pattern 3200, and a second CPW pattern 3400. The fourth ground pattern 3200 may be formed on at least the connecting portion 31.

The first CPW pattern 3300 of the second board layer 300b may be connected to the sub-antenna 21 in the predetermined region 43 of the opaque region 12. One end of a first feed pattern 3310 of the first CPW pattern 3300 may be connected to a sub-feed line of the antenna pattern of the sub-antenna 21. One end of a first ground pattern 3320 and one end of a second ground pattern 3330 of the first CPW pattern 3300 may be respectively connected to a sub-ground pattern of the antenna pattern of the sub-antenna 21.

A third feed pattern 3610 of the third CPW pattern 3600 may electrically connect the first feed pattern 3310 of the first CPW pattern 3300 and a second feed pattern 3410 of the second CPW pattern 3400.

The third feed pattern 3610 of the third CPW pattern 3600 and the first feed pattern 3310 of the first CPW pattern 3300 may overlap in a predetermined region 3020. The third feed pattern 3610 of the third CPW pattern 3600 may be electrically connected to the first feed pattern 3310 of the first CPW pattern 3300 through at least one third via 313.

The third feed pattern 3610 of the third CPW pattern 3600 and the second feed pattern 3410 of the second CPW pattern 3400 may overlap in a predetermined region 3030. The third feed pattern 3610 may be electrically connected to the second feed pattern 3410 of the second CPW pattern 3400 through at least one fourth via 314.

The first ground pattern 3320 and the second ground pattern 3330 of the first CPW pattern 330 may be electrically connected to the fourth ground pattern 3200. The first feed pattern 3310 and the first and second ground patterns 3320 and 3330 may be electrically isolated from each other.

A third ground pattern 3420 of the second CPW pattern 3400 may be electrically connected to the fourth ground pattern 3200. The second feed pattern 3410 and the third ground pattern 3420 may be electrically isolated from each other.

The fourth CPW pattern 3600 and the fourth ground pattern 3200 may constitute a pattern of a GCPW structure.

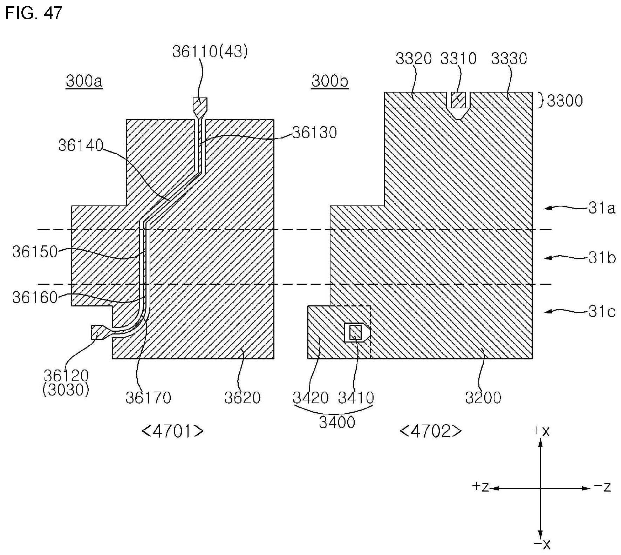

Referring to reference numeral 4701 of FIG. 47, the third CPW pattern 3600 may be formed on the first board layer 300a. The third CPW pattern 3600 may include a third feed pattern 3610 and a fifth ground pattern 3620.

The third feed pattern 3610 may include one end portion 36110 overlapping the first feed pattern 3310 of the first CPW pattern 3300, the other end portion 36120 overlapping the second feed pattern 3410 of the second CPW pattern 3400, a first line portion 36130 extending from the one end portion 36110 along an -x-axis direction, a second line portion 36140 extending from an end of the first line portion 36130 and bent by a predetermined angle in a +z-axis direction, a third line portion 36150 extending from an end of the second line portion 36140 along the -x-axis direction, a fourth line portion 36160 extending from an end of the third line portion 36150 along the -x-axis direction, and/or a fifth line portion 36170 connecting an end of the fourth line portion 36160 and the other end portion 36120.

The fifth line portion 36170 may be formed in a curved shape so as to connect the end of the fourth line portion 36160 and the other end portion 36120.

Referring to reference numeral 4702 of FIG. 47, the first CPW pattern 3300, the fourth ground pattern 3200, and the second CPW pattern 3400 may be formed on the second board layer 300b.

The first feed pattern 3310 of the first CPW pattern 3300 may overlap the one end portion 36110 of the third feed pattern 3610. The first ground pattern 3320 and the second ground pattern 3330 of the first CPW pattern 3300 may be connected to the fourth ground pattern 3200.

The second feed pattern 3410 of the second CPW pattern 3400 may overlap the other end portion 36120 of the third feed pattern 3610. The third ground pattern 3420 of the second CPW pattern 3400 may be connected to the fourth ground pattern 3200.

The fourth ground pattern 3200 may be electrically connected to the fifth ground pattern 3620 of the third CPW pattern 3600.

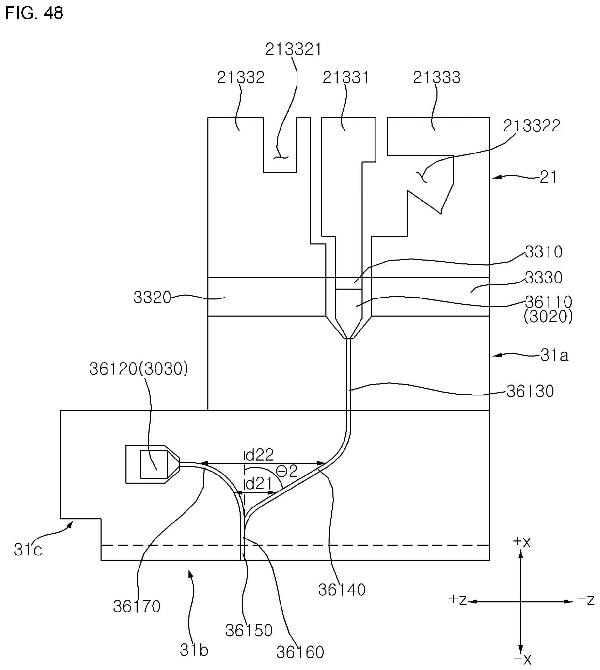

Referring to FIG. 48, the sub-antenna 21 may include a sub-feed line 21331, a first sub-ground pattern 21332, and a second sub-ground pattern 21333. The sub-feed line 21331 may be connected to the first feed pattern 3310 of the first CPW pattern 3300. The first sub-ground pattern 21332 may be connected to the first ground pattern 3320 of the first CPW pattern 3300. The second sub-ground pattern 21333 may be connected to the second ground pattern 3330 of the first CPW pattern 3300.

The sub-antenna 21 may include at least one slit pattern. The slit pattern may refer to a pattern formed by a portion of an edge of a sub-ground pattern being recessed inward. As an area of the slit pattern increases, an area of the sub-ground pattern may decrease. The slit pattern may be formed at a predetermined position and in a predetermined shape to enhance antenna efficiency.

The sub-antenna 21 may include a first slit pattern 213321 formed by a portion of an edge of the first sub-ground pattern 21332 being recessed inward. The first slit pattern 213321 may be formed such that a portion of an edge of the first sub-ground pattern 21332 adjacent to the antenna pattern of the main antenna 20 is recessed along the -x-axis direction. The first slit pattern 213321 may be formed in a rectangular shape.

The sub-antenna 21 may include a second slit pattern 213322 formed by a portion of an edge of the second sub-ground pattern 21333 being recessed inward. The second slit pattern 213322 may be formed such that a portion of an edge of the second sub-ground pattern 21333 adjacent to the sub-feed line 21331 is recessed along a -z-axis direction. The second slit pattern 213322 may be formed in a fan shape.

When the board 30 is disposed in a bent manner such that the second part 31b of the board 30 is convex toward the outside of the lateral side of the glass 10', the first part 31a and the third part 31c of the board 30 may overlap each other. In this case, an angle formed by orthogonal projections of the second line portion 36140 formed on the first part 31a and the fourth line portion 36160 formed on the third part 31c onto the first part 31a may be a predetermined angle ($\Theta 2$). Here, when the second line portion 36140 is formed by extending from an end of the first line portion 36130, the predetermined angle ($\Theta 2$) may correspond to an angle at which the second line portion 36140 is bent from the end of the first line portion 36130 in the +z-axis direction.

A gap in the z-axis direction between the orthogonal projections of the second line portion 36140 and the fourth line portion 36160 onto the first part 31a may increase as a distance from the third line portion 36150 increases. A gap in the z-axis direction between an orthogonal projection of the fifth line portion 36170 onto the first part 31a and the first line portion 36130 may increase as the distance from the third line portion 36150 increases. For example, the gap in the z-axis direction between the orthogonal projection of the fifth line portion 36170 onto the first part 31a and the first line portion 36130 may gradually increase to d21 and d22 as the distance from the third line portion 36150 increases.

The gap in the z-axis direction between the orthogonal projection of the fifth line portion 36170 onto the first part 31a and the first line portion 36130 may be greater than or equal to the gap in the z-axis direction between the orthogonal projections of the second line portion 36140 and the fourth line portion 36160 onto the first part 31a.

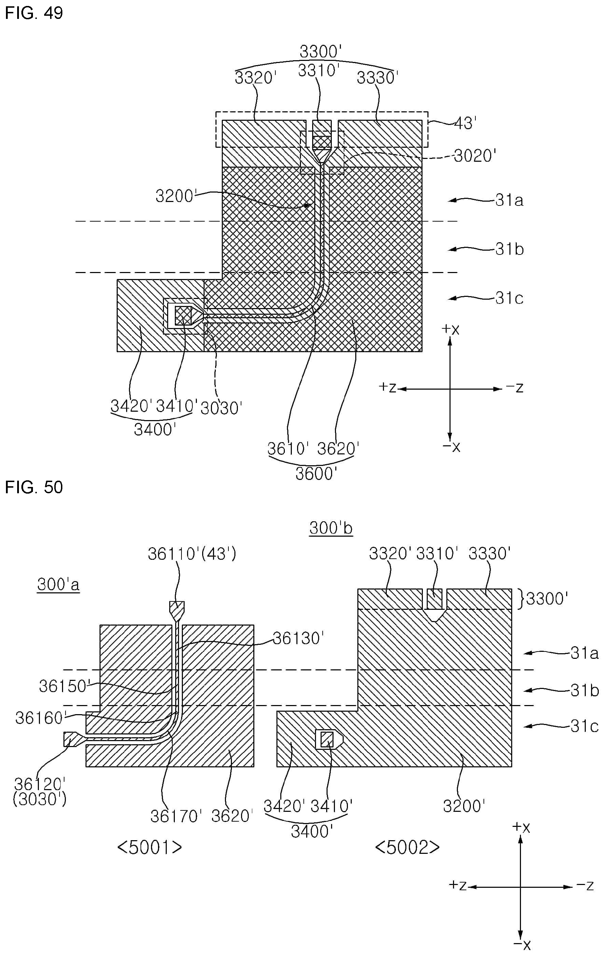

Referring to FIGS. 49 and 50, a first board layer 300'a may include a third CPW pattern 3600'. A second board layer 300'b may include a first CPW pattern 3300', a fourth ground pattern 3200', and a second CPW pattern 3400'. The fourth ground pattern 3200' may be formed on at least the connecting portion 31.

The third CPW pattern 3600' may include a third feed pattern 3610' and a fifth ground pattern 3620'.

The third feed pattern 3610' may include one end portion 36110' overlapping a first feed pattern 3310' of the first CPW pattern 3300', the other end portion 36120' overlapping a second feed pattern 3410' of the second CPW pattern 3400', a first line portion 36130' extending from the one end portion 36110' along the -x-axis direction, a third line portion 36150' extending from an end of the first line portion 36130' along the -x-axis direction, a fourth line portion 36160' extending from an end of the third line portion 36150' along the -x-axis direction, and/or a fifth line portion 36170' connecting an end of the fourth line portion 36160' and the other end portion 36120'.

The fifth line portion 36170' may be formed in a curved shape so as to connect the end of the fourth line portion 36160' and the other end portion 36120'.

The first CPW pattern 3300', the fourth ground pattern 3200', and the second CPW pattern 3400' may be formed on the second board layer 300'b.

The first feed pattern 3310' of the first CPW pattern 3300' may overlap the one end portion 36110' of the third feed pattern 3610. A first ground pattern 3320' and a second ground pattern 3330' of the first CPW pattern 3300' may be connected to the fourth ground pattern 3200'.

The second feed pattern 3410' of the second CPW pattern 3400' may overlap the other end portion 36120' of the third feed pattern 3610'. A third ground pattern 3420' of the second CPW pattern 3400' may be connected to the fourth ground pattern 3200'.

The fourth ground pattern 3200' may be electrically connected to the fifth ground pattern 3620' of the third CPW pattern 3600'.

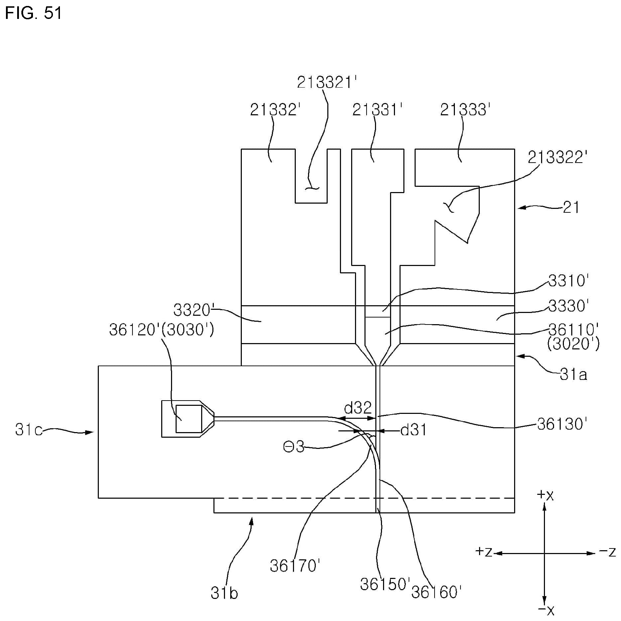

Referring to FIG. 51, when the board 30 is disposed in a bent manner such that the second part 31b of the board 30 is convex toward the outside of the lateral side of the glass 10', the first part 31a and the third part 31c of the board 30 may overlap each other.

In this case, an angle formed by orthogonal projections of the first line portion 36130' formed on the first part 31a and the fifth line portion 36170' formed on the third part 31c onto the first part 31a may be greater than or equal to a predetermined angle (Θ3).

A gap in the z-axis direction between the orthogonal projections of the first line portion 36130' and the fifth line portion 36170' onto the first part 31a may increase as a distance from the third line portion 36150' increases. For example, the gap in the z-axis direction between the orthogonal projections of the first line portion 36130' and the fifth line portion 36170' onto the first part 31a may gradually increase to d31 and d32 as the distance from the third line portion 36150' increases.

As described above, according to at least one embodiment of the present disclosure, it is possible to stably connect the antenna 20 and the connector 130.

Additionally, according to at least one embodiment of the present disclosure, it is possible to provide various structures optimized for a position of a glass, of two sheets of glass 10 and 10a, to which an antenna is attached.

Additionally, according to at least one embodiment of the present disclosure, it is possible to minimize a thickness of a flexible printed circuit board.

Additionally, according to at least one embodiment of the present disclosure, it is possible to reduce feed loss for the antenna 20 operating over a wideband.

Additionally, according to at least one embodiment of the present disclosure, it is possible to improve efficiency of the antenna 20 operating over a wideband.

Additionally, according to at least one embodiment of the present disclosure, it is possible to prevent interference between feed lines, thereby reducing feed loss.

Additionally, according to at least one embodiment of the present disclosure, it is possible to provide an antenna optimized for the area of an opaque region of glass.

Referring to FIGS. 1 to 51, a flexible printed circuit board according to one aspect of the present disclosure, which is composed of a plurality of layers, may include: a first board portion including a first feed pattern disposed on any one of the plurality of layers and electrically connected to an antenna, and a plurality of first ground patterns disposed on both sides of the first feed pattern; a second board portion including a second feed pattern disposed on any one of the plurality of layers and electrically connected to a cable, and a plurality of second ground patterns disposed on both sides of the second feed pattern; and a third board portion disposed between the first board portion and the second board portion, and covering a portion of a lateral side of a glass. The third board portion may include a third feed pattern disposed on a first layer of the plurality of layers that is adjacent to the glass, and a third ground pattern disposed on a second layer. Both ends of the third feed pattern may be electrically connected to the first feed pattern and the second feed pattern, respectively, and both ends of the third ground pattern may be electrically connected to the first ground pattern and the second ground pattern, respectively. The third feed pattern may include a first feed part adjacent to one surface of the glass, a second feed part adjacent to the lateral side of the glass, and a third feed part adjacent to the other surface of the glass. A gap between orthogonal projections of the first feed part and the third feed part may increase as a distance from the second feed part increases.

In addition, according to one aspect of the present disclosure, the third board portion may include a

plurality of fourth ground patterns disposed on the first layer and arranged on both sides of the third feed pattern.

In addition, according to one aspect of the present disclosure, the first feed part may include: a first line portion extending in a first direction from one end of the third feed pattern electrically connected to the first feed pattern; and a second line portion extending and bent by a predetermined angle from an end of the first line portion in a second direction perpendicular to the first direction. The second feed part may include a third line portion extending from an end of the second line portion, and the third feed part may include a fourth line portion extending from an end of the third line portion in the first direction.

In addition, according to one aspect of the present disclosure, the third line portion may extend along the first direction.

In addition, according to one aspect of the present disclosure, the third feed part may include a fifth line portion connecting an end of the fourth line portion and the other end of the third feed pattern electrically connected to the second feed pattern. The fifth line portion may be formed in a curved shape along the second direction.

In addition, according to one aspect of the present disclosure, a gap between orthogonal projections of the first line portion and the fifth line portion may exceed a gap between orthogonal projections of the second line portion and the fourth line portion.

In addition, according to one aspect of the present disclosure, an angle formed by the orthogonal projections of the first feed part and the third feed part may be greater than or equal to a predetermined angle corresponding to a maximum value of a length of a predetermined region in which the orthogonal projections of the first feed part and the third feed part overlap.

In addition, according to one aspect of the present disclosure, the maximum value of the length of the predetermine region may be determined based on a guided wavelength corresponding to a maximum value of a frequency used for communication through the antenna.

An antenna assembly according to another aspect of the present disclosure may include: a main antenna including a main feed line and a plurality of main ground patterns; a sub-antenna including a sub-feed line connected to the main feed line, and a plurality of sub-ground patterns connected to the plurality of main ground patterns; and a flexible printed circuit board composed of a plurality of layers. The flexible printed circuit board may include: a first board portion including a first feed pattern disposed on any one of the plurality of layers and connected to the sub-feed line, and a plurality of first ground patterns connected to the plurality of sub-ground patterns; a second board portion including a second feed pattern disposed on any one of the plurality of layers and electrically connected to a cable, and a plurality of second ground patterns disposed on both sides of the second feed pattern; and a third board portion disposed between the first board portion and the second board portion and covering a portion of a lateral side of a glass. The third board portion may include a third feed pattern disposed on a first layer of the plurality of layers that is adjacent to the glass, and a third ground pattern disposed on a second layer. Both ends of the third feed pattern may be electrically connected to the first feed pattern and the second feed pattern, respectively, and both ends of the third ground pattern may be electrically connected to the first ground pattern and the second ground pattern, respectively. The third feed pattern may include a first feed part adjacent to one surface of the glass, a second feed part adjacent to the lateral side of the glass, and a third feed part adjacent to the other surface of the glass. A gap between orthogonal projections of the first feed part and the third feed part may increase as a distance from the second feed part increases.

In addition, according to another aspect of the present disclosure, the main antenna and the sub-antenna may be positioned in a transparent region of the glass, and the flexible printed circuit board may be positioned in an opaque region.

In addition, according to another aspect of the present disclosure, a transparency of the sub-antenna may be lower than a transparency of the main antenna.

In addition, according to another aspect of the present disclosure, a sheet resistance of the sub-antenna may be smaller than a sheet resistance of the main antenna.

In addition, according to another aspect of the present disclosure, a frequency of a signal corresponding to the sub-antenna may exceed a frequency of a signal corresponding to the main antenna.

In addition, according to another aspect of the present disclosure, the first feed part may include: a first line portion extending in a first direction from one end of the third feed pattern electrically connected to the first feed pattern; and a second line portion extending and bent by a predetermined angle from an end of the first line portion in a second direction perpendicular to the first direction. The second feed part may include a third line portion extending from an end of the second line portion, and the third feed part may include a fourth line portion extending from an end of the third line portion along the first direction.

In addition, according to another aspect of the present disclosure, the first feed part may include a first line portion extending in a first direction from one end of the third feed pattern electrically connected to the first feed pattern. The second feed part may include a third line portion extending from an end of the first line portion. The third feed part may include: a fourth line portion extending from an end of the third line portion in the first direction; and a fifth line portion connecting an end of the fourth line portion and the other end of the third feed pattern electrically connected to the second feed pattern. The fifth line portion may be formed in a curved shape along a second direction perpendicular to the first direc-

tion.

The accompanying drawings are provided merely to facilitate understanding of the embodiments of the disclosure disclosed herein, and the technical idea of the present disclosure is not limited by the accompanying drawings. As such, the present disclosure should be construed to extend to any alterations, equivalents and substitutes in addition to those which are particularly set out in the accompanying drawings.

Meanwhile, an operation method of the present disclosure can be embodied as processor-readable code on a processor-readable recording medium. The processor-readable recording medium may include any type of recording device capable of storing data readable by a processor. Examples of the processor-readable recording medium may include ROM, RAM, CD-ROM, magnetic tape, floppy disks, and optical data storage devices, and also include implementations in the form of carrier waves, such as transmission via the Internet. In addition, the processor-readable recording medium may be distributed over network-connected computer systems, such that the processor-readable code can be stored and executed in a distributed manner.

It will be apparent that, although the preferred embodiments have been shown and described above, the present disclosure is not limited to the above-described specific embodiments, and various modifications and variations can be made by those skilled in the art without departing from the gist of the appended claims. Thus, it is intended that the modifications and variations should not be understood independently of the technical spirit or prospect of the present disclosure.

## Claims

1. A flexible printed circuit board composed of a plurality of layers, the flexible printed circuit board comprising:

   a first board portion including a first feed pattern disposed on any one of the plurality of layers and electrically connected to an antenna, and a plurality of first ground patterns disposed on both sides of the first feed pattern;
   a second board portion including a second feed pattern disposed on any one of the plurality of layers and electrically connected to a cable, and a plurality of second ground patterns disposed on both sides of the second feed pattern; and
   a third board portion disposed between the first board portion and the second board portion, and covering a portion of a lateral side of a glass,
   wherein the third board portion includes a third feed pattern disposed on a first layer of the plurality of layers that is adjacent to the glass, and a third ground pattern disposed on a second layer,
   wherein both ends of the third feed pattern are electrically connected to the first feed pattern and the second feed pattern, respectively; and both ends of the third ground pattern are electrically connected to the first ground pattern and the second ground pattern, respectively,
   wherein the third feed pattern includes a first feed part adjacent to one surface of the glass, a second feed part adjacent to the lateral side of the glass, and a third feed part adjacent to the other surface of the glass, and
   wherein a gap between orthogonal projections of the first feed part and the third feed part increases as a distance from the second feed part increases.

2. The flexible printed circuit board of claim 1, wherein the third board portion includes a plurality of fourth ground patterns disposed on the first layer and arranged on both sides of the third feed pattern.

3. The flexible printed circuit board of claim 1, wherein the first feed part includes:

   a first line portion extending in a first direction from one end of the third feed pattern electrically connected to the first feed pattern; and
   a second line portion extending and bent by a predetermined angle from an end of the first line portion in a second direction perpendicular to the first direction,
   wherein the second feed part includes a third line portion extending from an end of the second line portion, and
   wherein the third feed part includes a fourth line portion extending from an end of the third line portion in the first direction.

4. The flexible printed circuit board of claim 3, wherein the third line portion extends along the first direction.

5. The flexible printed circuit board of claim 3, wherein the third feed part includes a fifth line portion connecting an end of the fourth line portion and the other end of the third feed pattern electrically connected to the second feed pattern, and
   wherein the fifth line portion is formed in a curved shape along the second direction.

6. The flexible printed circuit board of claim 5, wherein a gap between orthogonal projections of the first line portion and the fifth line portion exceeds a gap between orthogonal projections of the second line portion and the fourth line portion.

7. The flexible printed circuit board of claim 1, wherein an angle formed by the orthogonal projections of the first feed part and the third feed part is greater than or

equal to a predetermined angle corresponding to a maximum value of a length of a predetermined region in which the orthogonal projections of the first feed part and the third feed part overlap.

**8.** The flexible printed circuit board of claim 7, wherein the maximum value of the length of the predetermine region is determined based on a guided wavelength corresponding to a maximum value of a frequency used for communication through the antenna.

**9.** An antenna assembly comprising:

a main antenna including a main feed line and a plurality of main ground patterns;
a sub-antenna including a sub-feed line connected to the main feed line, and a plurality of sub-ground patterns connected to the plurality of main ground patterns; and
a flexible printed circuit board composed of a plurality of layers,
wherein the flexible printed circuit board includes:

a first board portion including a first feed pattern disposed on any one of the plurality of layers and connected to the sub-feed line, and a plurality of first ground patterns connected to the plurality of sub-ground patterns;
a second board portion including a second feed pattern disposed on any one of the plurality of layers and electrically connected to a cable, and a plurality of second ground patterns disposed on both sides of the second feed pattern; and
a third board portion disposed between the first board portion and the second board portion and covering a portion of a lateral side of a glass,
wherein the third board portion includes a third feed pattern disposed on a first layer of the plurality of layers that is adjacent to the glass, and a third ground pattern disposed on a second layer,
wherein both ends of the third feed pattern are electrically connected to the first feed pattern and the second feed pattern, respectively; and
both ends of the third ground pattern are electrically connected to the first ground pattern and the second ground pattern, respectively,
wherein the third feed pattern includes a first feed part adjacent to one surface of the glass, a second feed part adjacent to the lateral side of the glass, and a third feed part adjacent to the other surface of the glass, and
wherein a gap between orthogonal projections of the first feed part and the third feed part increases as a distance from the second feed part increases.

**10.** The antenna assembly of claim 9, wherein:

the main antenna and the sub-antenna are positioned in a transparent region of the glass; and the flexible printed circuit board is positioned in an opaque region.

**11.** The antenna assembly of claim 9, wherein a transparency of the sub-antenna is lower than a transparency of the main antenna.

**12.** The antenna assembly of claim 9, wherein a sheet resistance of the sub-antenna is smaller than a sheet resistance of the main antenna.

**13.** The antenna assembly of claim 9, wherein a frequency of a signal corresponding to the sub-antenna exceeds a frequency of a signal corresponding to the main antenna.

**14.** The antenna assembly of claim 9, wherein the first feed part includes:

a first line portion extending in a first direction from one end of the third feed pattern electrically connected to the first feed pattern; and
a second line portion extending and bent by a predetermined angle from an end of the first line portion in a second direction perpendicular to the first direction,
wherein the second feed part includes a third line portion extending from an end of the second line portion, and
wherein the third feed part includes a fourth line portion extending from an end of the third line portion along the first direction.

**15.** The antenna assembly of claim 9, wherein the first feed part includes a first line portion extending in a first direction from one end of the third feed pattern electrically connected to the first feed pattern,

wherein the second feed part includes a third line portion extending from an end of the first line portion,
wherein the third feed part includes:

a fourth line portion extending from an end of the third line portion in the first direction; and
a fifth line portion connecting an end of the fourth line portion and the other end of the

third feed pattern electrically connected to the second feed pattern, and
wherein the fifth line portion is formed in a curved shape along a second direction perpendicular to the first direction.

FIG. 1

1

HEIGHT
DIRECTION(H)
WIDTH
DIRECTION(W)
OVERALL-LENGTH
DIRECTION(L)

FIG. 2

1
10a
200a
200c
200b

FIG. 3

1
102
200d
200e
103
200f

FIG. 4

1
431
432
433
434
435
436
437
438
439
USER INTERFACE DEVICE
DRIVING CONTROL DEVICE
VEHICLE OPERATING DEVICE
OPERATION SYSTEM
NAVIGATION SYSTEM
SENSING UNIT
INTERFACE
MEMORY
POWER SUPPLY
440
CONTROLLER
OBJECT DETECTION DEVICE
411
PROCESSOR
CAMERA
RADAR
LiDAR
ULTRASONIC SENSOR
INFRARED SENSOR
410
412
413
414
415
416
COMMUNICATION DEVICE
421
PROCESSOR
SHORT-RANGE COMMUNICATION UNIT
POSITION INFORMATION UNIT
V2X COMMUNICATION UNIT
OPTICAL COMMUNICATION UNIT
BROADCAST TRANSCEIVER
ITS COMMUNICATION UNIT
420
422
423
424
425
426
427

FIG. 5

9h
9
9g
10,10'
11
12
20
8

FIG. 6

9
9g
12
12a
7
9h
11
8
100
12a
120
111b
110
20
130
10
30

FIG. 7


H11
W10
H12
100a
(100)
11
100b
(100)
20
11
10
12
110,120
20
12
10
130
30

FIG. 8

10
11
12
13
20b(20)
120
130
C2
100b(100)
L
L'
20a(20)
C1
130
120
100a(100)

FIG. 9

113
114
115
100a(100)
112
123
121
122
120
134
132
133
131
130
110
30
U
Ri
R
F
Le
D
y
z
x

FIG. 10

113
114
100b(100)
115
112
110
30
123
121
122
120
131
133
132
134
130
U
R
Le
Ri
F
D
y
x
z

FIG. 11

100a(100)
122a
122S
122h3
W22
122
121
123
122h2
W21
122h1
h22
L20
h21
120
112a
112b
112
113a
113b
113
114a
114b
114
112b
112b2
114b
112b1
114bh
113a
113a2
113a1
113b
113b2
d21
d22
113b1
P2
112a1
SL2
112a2
SL5
115h
114ah
111L2
SL1
d1
115
112a
L1
W1
SL4
L10
111S2
SL3
111S1
114a
111h
111L1
111b
111
111a
P1
110
y
z
x

FIG. 12

10'
20b(20)
10a
10Y
10
11
12
30b(30)
20a(20)
30a(30)

FIG. 13

122S
112a
122
121
123
120
112
113
115
110
P2
P1
110
120
130
100a
(100)
114
111h
111a
111
20
130
32
40
y
z
x
31c
31b
31a
10
10'
10Y
31

FIG. 14

113b
113b1 113b2
113a
113a2 113a1
115h
(115)
120
123 121 122
114ah
(114a)
114bh
(114b)
112b2
112b1
112b
131
132
130
20
110
110
120
130
100b
(100)
10 10a
10'
31c 31b 31a
31
10Y
32
33,40
13
112a2
112a1
112a
122a
y
x
z

FIG. 15

120'
121'
122'
112b1'
(112b')
130
130a
130b
114bh'
(114b')
20a(20)
112a1'
(112a')
110'
114ah'
(114a')
113b1'
(113b')
110'
111b'
(111')
121g'
33,40
32
113ah'
(113a')
10a
10
10'
y
x
z
10Y
31a
31b
31c
31
110'
120'
130'
100b'
(100')

FIG. 16

114bh
(114b)
115h
(115)
122(120)
114ah
(114a)
133
131
130
132
134
40
33
30
32
31
h1
g1
R3
111a
10,10' 130P
130Q
111h
(110)
111b
130P
110
120
130
100

FIG. 17

9
7
100
30
20
10Y
10
10a
7
9
-x
+y
-y
+x

FIG. 18

30b
30
320
30a
320
350
40
312
340
130P
311
330
130Q
130P
320
340
110
10a
10Y
20'
20
20Y
10
+y
-y
+x
-x

FIG. 19

330
332
331
333
301
302
320
350
303
3211
30Ph
30Qh
341
342
340
+x
-x
+z
-z

FIG. 20

30b
3201
320
3211
322
3202
323
324
<2002>
30Ph

30a
330
333
3322
331
3321
3311
332
3301
350
351
352
353
354
30Qh
340
341
342
<2001>
30Ph

FIG. 21

302
332
331
3311
333
W1
S1
W12
S2
L1
330
W2
320
350

FIG. 22

320
353(350)
W4
S4
L2
354(350)
W34
W3
W3
303
303
341
30Ph

FIG. 23

332
331
333
3202
330
3211
320

FIG. 24

9
7
100
30'
20
10Y
10a
10
7
9
-x
+y
-y
+x

FIG. 25

30'b
30'
320'
350
30'a
340'
312
40
130P
130Q
130P
320'
340
110
313
330'
320'
+y
-y
-x
+x
10a
20Y
20
20'
10Y
10

FIG. 26

330'
332'
331'
333'
301'
302'
320'
350'
303
3211'
39Ph
30Qh
341'
342'
340'

FIG. 27

FIG. 28

30"b
30"
320"
360
30"a
320"
314
313
340"
330"
−x
+y
−y
+x
10a
20Y
20
20'
10Y
10

FIG. 29a

330"
332"
331"
333"
301"
302"
320"
31a
31b
31c
362
360
361
2900
+x
+z
-z
-x
342"
341"
303"
340"

FIG. 29b

290
362
361
362
S
W
S
h
320"
30"
+y
+z
-z
-y

FIG. 30

30"a
3611(302")
3613
3614
362
362
3615
3616
3612(303")
3617
<3001>
30"b
332"
331"
333"
330"
3311"
320"
31a
31b
31c
342"
341"
340"
<3002>
+x
+z
-z
-x

FIG. 31

3612(341")
3611(3311")
3613
d13
31a
3617
d12
3614
3616
Θ1
d11
31c
+x
+z
-z
-x
31b
3615

FIG. 32

30
361a
31a
361b
31b
361c
31c
+x
+z
-z
-x

<3201>

E Field [V/m]
2000.0000
1866.6666
1733.3333
1600.0000
1466.6666
1333.3333
1200.0000
1066.6666
933.3333
800.0000
666.6666
533.3333
400.0000
266.6667
133.3333
0.0000
+y
+z
-z
-y

<3202>

FIG. 33

30
31c
361c
31a
361a
31b
361b
<3301>
+y
+x
+z
-z
-x
-y
E Field [V/m]
2000.0000
1866.6666
1733.3333
1600.0000
1466.6666
1333.3333
1200.0000
1066.6666
933.3333
800.0000
666.6666
533.3333
400.0000
266.6667
133.3333
0.0000
<3302>
+y
+z
-z
-y

FIG. 34

G3410
G3420
0.00
-1.00
-2.00
-3.00
-4.00
-5.00
Insertion Loss(dB)
0.50
1.50
2.50
3.50
4.50
5.50
6.00
Frequency(GHz)
<3401>

G3440
G3430
0.00
-5.00
-10.00
-15.00
-20.00
-25.00
-30.00
Return Loss (dB)
0.50
1.50
2.50
3.50
4.50
5.50
6.00
Frequency(GHz)
<3402>

FIG. 35

3611(3311")
3612(341")
3613
d13
3617
3614
d12
31a
Θ1
3616
d11
+x
31c
+z
-z
-x
<3501>
31b
3615
E Field [V/m]
2000.0000
1866.6666
1733.3333
1600.0000
1466.6666
1333.3333
1200.0000
1066.6666
933.3333
800.0000
666.6666
533.3333
400.0000
266.6667
133.3333
0.0000
+y
<3502>
+z
-z
-y

FIG. 36

0.00
-1.00
-2.00
-3.00
-4.00
-5.00
Insertion Loss(dB)
G3610
G3420
0.50
1.50
2.50
3.50
4.50
5.50
6.00
Frequency(GHz)
<3601>

0.00
-5.00
-10.00
-15.00
-20.00
-25.00
-30.00
Return Loss (dB)
G3440
G3630
0.50
1.50
2.50
3.50
4.50
5.50
6.00
Frequency(GHz)
<3602>

FIG. 37

30
361a
361c
L1
361a
(361c)
361b
<3701>
30
361a
361c
L2
361a
(361c)
361b
<3702>

FIG. 38

G3820
0.00
-1.00
-2.00
-3.00
-4.00
-5.00
Insertion Loss(dB)
G3810
0.50
1.50
2.50
3.50
4.50
5.50
6.00
Frequency(GHz)
<3801>

0.00
-5.00
-10.00
-15.00
-20.00
-25.00
-30.00
Return Loss (dB)
G3830
G3840
0.50
1.50
2.50
3.50
4.50
5.50
6.00
Frequency(GHz)
<3802>

FIG. 39

3612(341")
3611(3311")
3613
3617
G11
3618
3616
3614
Θ11
Lm
31a
31c
L11
<3901>
31b
3615
3611(3311")
3612(341")
3613
3617
G12
3614
Lm
3616
Θ12
31a
31c
L12
<3902>
31b
3615

FIG. 40

20b(20)
9g
9
10a
10am
10ae
10Y
21b(21)
10Ym
10am
30b(30)
10ye
y
x
z
30a(30)
20a(20) 11
12
10
10Ym
21a(21)

FIG. 41

10Ye
10ae
100
30
21
20
9
10a
10Y
10
12
11
+y
-x
+x
-y

FIG. 42

30a(30)
21a(21)
20a(20)
30b(30)
21b(21)
20b(20)
y
z
x

FIG. 43

10
11
12
+z
-z
+x
-x
20b(20)
21b(21)
43b(43)
30b(30)
20a(20)
21a(21)
43a(43)
30a(30)

FIG. 44

A20
A21
A30
A20
A21
A30
<4401-0.6GHz>
<4402-1.9GHz>

A20
A21
A30
A20
A21
A30
<4403-2.7GHz>
<4404-5GHz>

FIG. 45

0.00
-5.00
-10.00
-15.00
-20.00
-25.00
-30.00
S Parameter (dB)
0.00 0.50 1.00 1.50 2.00 2.50 3.00 3.50 4.00 4.50 5.00 5.50 6.00
Frequency(GHz)
G4530
G4520
G4510
G4540

<4501>

0.00
-0.50
-1.00
-1.50
-2.00
-2.50
-3.00
-3.50
Efficiency (dB)
0.00 0.50 1.00 1.50 2.00 2.50 3.00 3.50 4.00 4.50 5.00 5.50 6.00
Frequency(GHz)
G4525
G4515
G4545
G4535

<4502>

FIG. 46

3300
3310
3320
3330
43
3020
3200
31a
31b
31c
+x
+z
-z
-x
3420
3410
3030
3610
3620
3400
3600

FIG. 47

36110(43)
300a
300b
3320 3310 3330
3300
36130
36140
31a
36150
31b
36160
31c
36120
(3030)
36170
3620
3420 3410
3400
3200
<4701>
<4702>
+x
+z
-z
-x

FIG. 48

213321
21332
21331
21333
213322
21
3310
3330
3320
36110
(3020)
31a
36120(3030)
36130
d22
Θ2
d21
31c
+x
36170
36140
+z
-z
36150
31b
36160
-x

FIG. 49

3300'
3320'
3310'
3330'
43'
3020'
3200'
31a
31b
31c
+x
+z
-z
-x
3420'
3410'
3030'
3400'
3610'
3620'
3600'

FIG. 50

300'b
36110'(43')
3320'
3310'
3330'
300'a
3300'
36130'
31a
36150'
31b
36160'
31c
36120'
(3030')
36170'
3620'
3420'
3410'
3400'
3200'
<5001>
<5002>
+x
+z
-z
-x

FIG. 51

213321'
21332'
21331'
21333'
213322'
21
3310'
3320'
3330'
36120'(3030')
36110'
(3020')
31a
d32
36130'
31c
d31
Θ3
+x
+z
-z
-x
36170'
31b
36150'
36160'

# INTERNATIONAL SEARCH REPORT

International application No.
**PCT/KR2023/016062**

**A. CLASSIFICATION OF SUBJECT MATTER**

**H01Q 1/38**(2006.01)i; **H05K 1/14**(2006.01)i; **H01Q 1/32**(2006.01)i; **H01Q 1/12**(2006.01)i; **H01R 13/59**(2006.01)i

According to International Patent Classification (IPC) or to both national classification and IPC

**B. FIELDS SEARCHED**

Minimum documentation searched (classification system followed by classification symbols)

H01Q 1/38(2006.01); H01Q 1/12(2006.01); H01Q 1/32(2006.01); H01Q 13/10(2006.01); H01Q 5/25(2015.01); H01Q 9/04(2006.01); H01R 13/646(2011.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 안테나(antenna), 연성인쇄회로기판(flexible printed circuit board), 그라운드(ground), 급전(feeding), 글라스(glass)

**C. DOCUMENTS CONSIDERED TO BE RELEVANT**

| Category* | Citation of document, with indication, where appropriate, of the relevant passages | Relevant to claim No. |
|---|---|---|
| A | KR 10-2017-0121274 A (SAINT-GOBAIN GLASS FRANCE) 01 November 2017 (2017-11-01) See paragraphs [0079]-[0095], claims 6 and 8 and figures 1a-6d. | 1-15 |
| A | KR 10-2021-0079262 A (SAMSUNG ELECTRO-MECHANICS CO., LTD.) 29 June 2021 (2021-06-29) See paragraphs [0059]-[0076] and figures 1-8b. | 1-15 |
| A | US 2023-0094098 A1 (LG ELECTRONICS INC.) 30 March 2023 (2023-03-30) See claim 1 and figures 5-18. | 1-15 |
| A | JP 2010-146959 A (ASAHI GLASS CO., LTD.) 01 July 2010 (2010-07-01) See claims 1-6 and figures 1-10. | 1-15 |
| A | US 2018-0151939 A1 (ASAHI GLASS COMPANY, LIMITED) 31 May 2018 (2018-05-31) See claims 1-20 and figures 2-32. | 1-15 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 July 2024** | **04 July 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2023/016062**

| Patent document cited in search report | Publication date (day/month/year) | Patent family member(s) | Publication date (day/month/year) |
|---|---|---|---|
| KR 10-2017-0121274 A | 01 November 2017 | BR 112017020048 A2 | 05 June 2018 |
| | | CA 2979604 A1 | 13 October 2016 |
| | | CA 2979604 C | 29 October 2019 |
| | | CN 106463813 A | 22 February 2017 |
| | | EA 035647 B1 | 21 July 2020 |
| | | EA 201792152 A1 | 28 February 2018 |
| | | EP 3281247 A1 | 14 February 2018 |
| | | EP 3281247 B1 | 23 December 2020 |
| | | ES 2849948 T3 | 24 August 2021 |
| | | JP 2018-513638 A | 24 May 2018 |
| | | JP 6632634 B2 | 22 January 2020 |
| | | KR 10-1972257 B1 | 24 April 2019 |
| | | MX 2017012810 A | 30 January 2018 |
| | | PL 3281247 T3 | 17 May 2021 |
| | | US 10737469 B2 | 11 August 2020 |
| | | US 2018-0037006 A1 | 08 February 2018 |
| | | WO 2016-162251 A1 | 13 October 2016 |
| KR 10-2021-0079262 A | 29 June 2021 | CN 110021815 A | 16 July 2019 |
| | | CN 110021815 B | 10 August 2021 |
| | | CN 113571888 A | 29 October 2021 |
| | | KR 10-2019-0080699 A | 08 July 2019 |
| | | KR 10-2019-0120135 A | 23 October 2019 |
| | | KR 10-2036546 B1 | 25 October 2019 |
| | | KR 10-2431578 B1 | 11 August 2022 |
| | | KR 10-2565120 B1 | 09 August 2023 |
| | | US 11088468 B2 | 10 August 2021 |
| | | US 2019-0207323 A1 | 04 July 2019 |
| | | US 2021-0320428 A1 | 14 October 2021 |
| US 2023-0094098 A1 | 30 March 2023 | EP 4156413 A1 | 29 March 2023 |
| | | US 11682824 B2 | 20 June 2023 |
| | | WO 2023-054734 A1 | 06 April 2023 |
| JP 2010-146959 A | 01 July 2010 | CN 101902001 A | 01 December 2010 |
| | | CN 101902001 B | 25 November 2015 |
| | | EP 2200123 A1 | 23 June 2010 |
| | | EP 2200123 B1 | 30 November 2016 |
| | | JP 5476713 B2 | 23 April 2014 |
| US 2018-0151939 A1 | 31 May 2018 | CN 107851889 A | 27 March 2018 |
| | | CN 107851889 B | 30 October 2020 |
| | | EP 3327862 A1 | 30 May 2018 |
| | | EP 3327862 A4 | 10 April 2019 |
| | | EP 3327862 B1 | 03 March 2021 |
| | | JP 6614237 B2 | 04 December 2019 |
| | | US 10297897 B2 | 21 May 2019 |
| | | WO 2017-018324 A1 | 02 February 2017 |

Form PCT/ISA/210 (patent family annex) (July 2022)